(19) Europäisches Patentamt / European Patent Office / Office européen des brevets

(11) **EP 3 772 071 B1**

(12) **EUROPÄISCHE PATENTSCHRIFT**

(45) Veröffentlichungstag und Bekanntmachung des Hinweises auf die Patenterteilung:
**26.01.2022   Patentblatt 2022/04**

(21) Anmeldenummer: **20186807.2**

(22) Anmeldetag: **20.07.2020**

(51) Internationale Patentklassifikation (IPC):
*H01F 6/06* (2006.01)       *G01R 33/3815* (2006.01)

(52) Gemeinsame Patentklassifikation (CPC):
**G01R 33/3815; H01F 6/065**

(54) **MAGNETSPULENSEKTION MIT INTEGRIERTEN JOINTS, INSBESONDERE HTS-LTS-JOINTS, UND ZUGEHÖRIGE MAGNETANORDNUNG**

MAGNETIC COIL SYSTEM WITH INTEGRATED JOINTS, IN PARTICULAR HTS-LTS JOINTS, AND ASSOCIATED MAGNET ASSEMBLY

SECTION DE BOBINE ÉLECTROMAGNÉTIQUE POURVUE DE JOINTS INTÉGRÉS, EN PARTICULIER JOINTS HTS-LTS, ET AGENCEMENT D'AIMANTS ASSOCIÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **31.07.2019   DE 102019211478**

(43) Veröffentlichungstag der Anmeldung:
**03.02.2021   Patentblatt 2021/05**

(73) Patentinhaber: **Bruker Switzerland AG
8117 Fällanden (CH)**

(72) Erfinder:
• **Herzog, Robert
  8002 Zürich (CH)**
• **Vonlanthen, Patrik
  8603 Schwerzenbach (CH)**

(74) Vertreter: **Kohler Schmid Möbus Patentanwälte
Partnerschaftsgesellschaft mbB
Gropiusplatz 10
70563 Stuttgart (DE)**

(56) Entgegenhaltungen:
WO-A1-2007/107239       DE-A1- 10 225 531
DE-A1-102013 220 142     GB-A- 2 388 909

## Beschreibung

Die Erfindung betrifft eine Magnetspulensektion, umfassend einen im Wesentlichen zylindermantelförmigen Spulenträger, einen Hochtemperatursupraleiter(=HTS)-Bandleiter und einen ersten Supraleiter(=SL)-Folgeleiter mit einem ersten Joint zwischen dem HTS-Bandleiter und dem ersten SL-Folgeleiter,

wobei der Spulenträger einen Hauptbereich aufweist, in welchem ein Hauptwickelpaket des HTS-Bandleiters solenoidförmig auf den Spulenträger aufgewickelt ist,

wobei der Spulenträger weiterhin einen ersten Seitenbereich aufweist, der sich axial an einer ersten Seite an den Hauptbereich anschließt, und in welchem ein erster Endabschnitt des HTS-Bandleiters auf den Spulenträger aufgewickelt ist, wobei zumindest in einem axial inneren Abschnitt des ersten Seitenbereichs der erste Endabschnitt des HTS-Bandleiters in einer nutenartigen Vertiefung des Spulenträgers geführt ist,

und wobei das Hauptwickelpaket des HTS-Bandleiters einen größten Außenradius RaH aufweist und der Spulenträger im Hauptbereich einen kleinsten Innenradius RiH aufweist.

Eine solche Magnetspulensektion ist bekannt geworden aus der DE 102 02 372 B4 (GB 2388909).

Supraleiter können unterhalb ihrer Sprungtemperatur elektrischen Strom praktisch ohne ohmsche Verluste tragen. Supraleiter werden insbesondere in Magnetspulen zur Erzeugung hoher Magnetfeldstärken eingesetzt, wie sie beispielsweise in der NMR-Spektroskopie benötigt werden.

Mit so genanntem Hochtemperatursupraleiter(=HTS)-Material, beispielsweise auf Basis von YBCO, können besonders hohe supraleitende Stromtragfähigkeiten genutzt werden. Allerdings sind HTS-Materialien in der Regel spröde, so dass diese im Magnetbau meist als Beschichtung auf einem flexiblen Substrat ("Bandleiter") eingesetzt werden. Die HTS-Beschichtung ist sehr empfindlich, so dass der Bandleiter möglichst nicht über seine kurze Seite gebogen werden sollte.

Tieftemperatursupraleiter(=LTS)-Materialien sind in der Regel metallische Materialien und können in einer Vielzahl von Geometrien eingesetzt werden. Mit NbTi steht dabei auch ein gut duktiles LTS-Material zur Verfügung.

In einem wichtigen Anwendungsfall zur Erzeugung hoher Magnetfeldstärken wird zur Herstellung einer Magnetspulensektion HTS-Bandleiter auf einen im Wesentlichen zylindermantelförmigen Spulenträger aufgewickelt. Eine Schwierigkeit ist dabei die Gestaltung von Eingängen und Ausgängen des HTS-Bandleiters bzw. die Einrichtung von elektrischen Verbindungen ("Joints") zu Supraleiter(=SL)-Folgeleitern, etwa zu einem leichter zu handhabenden NbTi-Draht.

Die US 3 559 128 beschreibt in der dortigen Fig. 2, einen auf einem Spulenkörper aufgewickelten supraleitenden Bandleiter am Randbereich der Wicklung mit einem entlang der Achse des Spulenkörpers geführten supraleitenden Streifen zu kreuzen und elektrisch zu verbinden. Nachteilig ist hier jedoch, dass der Joint in einem Bereich hoher Magnetfeldstärke und auch hoher mechanischer Kräfte liegt und daher die supraleitende Stromtragfähigkeit der Spule stark begrenzt ist.

Die US 3 559 128 beschreibt weiterhin in der Fig. 4, den auf einem Spulenkörper aufgewickelten Bandleiter am Randbereich der Wicklung sanft zu verdrehen und durch eine Öffnung im Flansch eines Spulenkörpers zu führen. Ein ähnliches Vorgehen wird in der DE 102 60 728 B4 vorgeschlagen. Hier wird der HTS-Bandleiter vom Rand der Wicklung entlang einer vorgegebenen Bahn verdreht und axial nach außen geführt, so dass der HTS-Bandleiter nicht über seine kurze Kante gebogen wird. Ein Joint zu einem SL-Folgeleiter erfolgt axial beabstandet von der Wicklung und somit in einem Bereich verringerter Magnetfeldstärke. Bei diesem Vorgehen ist jedoch der HTS-Bandleiter durch seine Verdrehung am Rand der Wicklung in einem Bereich noch hoher Magnetfeldstärke ungünstig orientiert, nämlich mit hohen Magnetfeldanteilen senkrecht zur Bandleiterebene, was die Stromtragfähigkeit begrenzt. Zudem ist der parallel zur Spulenachse liegende Verlauf des HTS-Bandleiters ungünstig für eine platzsparende Kontaktierung eines SL-Folgeleiters.

Die EP 2 645 382 beschreibt eine solenoidförmig gewickelte Spule mit einem Lagenjoint, wobei innerhalb eines Wickelpakets aufeinanderfolgende Teilstücke eines HTS-Bandleiters über eine gewisse Länge leitend miteinander verbunden werden. Der Joint ist in einem Bereich hoher Magnetfeldstärke und begrenzt daher die Stromtragfähigkeit. Zudem kann die Magnetfeldhomogenität nachteilig beeinflusst werden.

Die DE 10 2013 220 142 A1 beschreibt eine Magnetspulenanordnung mit einer inneren HTS-Spulensektion und einer äußeren LTS-Spulensektion. Der HTS-Bandleiter und der LTS-Draht werden in nicht näher erläuterter Weise axial aus ihren Spulensektionen herausgeführt und über wenigstens 5 m elektrisch normalleitend miteinander verbunden, und der Verbindungsabschnitt wird aufgewickelt. Dieser Aufbau ist vergleichsweise platzaufwändig.

Die eingangs erwähnte DE 102 02 372 B4 beschreibt eine Magnetspulensektion, bei der ein HTS-Bandleiter auf einem Spulenkörper solenoidförmig aufgewickelt ist. In einem Randbereich nimmt die Wickeldichte nach axial außen hin ab, und an einem axialen Ende des Spulenkörpers wird der HTS-Bandleiter schließlich radial vom Spulenkörper weggeführt, so dass in einem Bereich geringer Magnetfeldstärke ein Joint ausgebildet werden kann. Im Spulenkörper ist eine Nut zur Führung des HTS-Bandlieters ausgebildet. Dieser Aufbau ist wiederum sehr platzaufwändig.

Aus Manfredo P. do Carmo, Differentialgeometrie von Kurven und Flächen, Vieweg Verlag, Braunschweig 1983, S. 240, wird das Konzept einer Einhüllenden der rektifizierenden Ebenen zu einer parametrisierten Kurve erläutert.

Aufgabe der Erfindung

Es ist Aufgabe der Erfindung, eine Magnetspulensektion mit hoher Stromtragfähigkeit zur Verfügung zu stellen, die auf kompaktem Raum elektrische Verbindungen zum HTS-Bandleiter zur Verfügung stellen kann.

Beschreibung der Erfindung

Diese Aufgabe wird erfindungsgemäß gelöst durch eine Magnetspulensektion der eingangs genannten Art, die dadurch gekennzeichnet ist,

dass die Magnetspulensektion weiterhin einen zweiten SL-Folgeleiter mit einem zweiten Joint zum HTS-Bandleiter umfasst,
dass in dem ersten Seitenbereich oder in einem zweiten Seitenbereich, der sich axial an einer zweiten Seite an den Hauptbereich anschließt und der ersten Seite gegenüber liegt, ein zweiter Endabschnitt des HTS-Bandleiters auf den Spulenträger aufgewickelt ist,
dass zumindest in einem axial inneren Abschnitt des ersten oder zweiten Seitenbereichs der zweite Endabschnitt des HTS-Bandleiters in einer nutenartigen Vertiefung des Spulenträgers geführt ist,
dass in einem axial äußeren Abschnitt des ersten Seitenbereichs zumindest ein Teil des auf dem Spulenträger aufgewickelten ersten Endabschnitts des HTS-Bandleiters mit einem Endabschnitt des ersten SL-Folgeleiters flächig zur Ausbildung des ersten Joints verbunden ist, und zumindest ein Teil des auf dem Spulenträger aufgewickelten zweiten Endabschnitts des HTS-Bandleiters mit einem Endabschnitt des zweiten SL-Folgeleiters zur Ausbildung des zweiten Joints flächig verbunden ist,
dass der Spulenträger insgesamt, der HTS-Bandleiter insgesamt sowie der erste SL-Folgeleiter zumindest im Bereich des ersten Joints und der zweite SL-Folgeleiter zumindest im Bereich des zweiten Joints innerhalb eines Radialbereichs RBS der Magnetspulensektion verlaufen, mit
$0,80*RiH \leq RBS \leq 1,2*RaH$, bevorzugt $0,9*RiH \leq RBS \leq 1,1*RaH$, besonders bevorzugt $RiH \leq RBS \leq RaH$, und dass weiterhin

- der erste Joint und der zweite Joint jeweils über den gesamten Umfang des Spulenträgers reichen, und/oder
- der erste Joint und der zweite Joint sich jeweils über eine Überlappungslänge, bezogen auf den HTS-Bandleiter, von wenigstens 0,1 m, bevorzugt wenigstens 0,5 m, erstrecken.

Die Erfindung sieht vor, den ersten Joint und den zweiten Joint, mit denen der HTS-Bandleiter elektrisch mit einem ersten SL-Folgeleiter und einem zweiten SL-Folgeleiter verbunden wird, insbesondere supraleitend verbunden wird, jeweils in einem axial äußeren Abschnitt eines Seitenbereichs des Spulenträgers auszubilden, indem der erste und zweite Endabschnitt des HTS-Bandleiters mit Endabschnitten des ersten und zweiten SL-Folgeleiters überlappend flächig miteinander verbunden werden, wobei im Bereich des ersten und zweiten Joints der HTS-Bandleiter und der erste und zweite Folgeleiter auf dem Spulenträger aufgewickelt sind.

Der HTS-Bandleiter wird vom Hauptbereich, in welchem das Hauptwickelpaket die größte Magnetfeldstärke erzeugt, zunächst über einen axial inneren Abschnitt des Seitenbereichs nach axial weiter außen geführt, wobei eine nutenartige Vertiefung den HTS-Bandleiter führt und mechanisch stabilisiert. Im axial äußeren Abschnitt des Seitenbereichs herrscht eine deutlich niedrigere Magnetfeldstärke und entsprechend auch eine niedrigere mechanisch Krafteinwirkung durch Lorenzkräfte, so dass hier der erste und zweite Joint ausgebildet werden können, ohne die Stromtragfähigkeit oder Stabilität negativ zu beeinflussen. Der erste und zweite Joint sind typischerweise jeweils mindestens um das 1,5-fache des maximalen Außenradius RaH des Hauptwickelpakets vom Hauptwickelpaket axial beabstandet (gemessen Rand zu Rand).

Da die Wicklung des HTS-Bandleiters vom Hauptbereich über den axial inneren Abschnitt bis in den axial äußeren Abschnitt mit dem Joint im Wesentlichen auf dem Spulenträger einfach weitergewickelt wird (wenn auch zumindest überwiegend mit größerer Ganghöhe als im Hauptwickelpaket, um Inhomogenitäten des Magnetfelds zu minimieren), und insbesondere keine Verdrehung (Verdrillung, Twist) des HTS-Bandleiters nötig ist, ist der erfindungsgemäße Aufbau mechanisch robust und der HTS-Bandleiter im Allgemeinen auch für die Stromtragfähigkeit günstig zum erzeugten Magnetfeld orientiert. Auch dies trägt zu einer hohen Stromtragfähigkeit bei.

Durch Aufwickeln des ersten und zweiten Joints auf den Spulenträger können auf kompaktem Raum vergleichsweise große Überlappungsflächen (oder Überlappungslängen) eingerichtet werden, wodurch die elektrische Verbindung zuverlässig und ohne merklichen ohmschen Widerstand leicht eingerichtet werden kann. Die flächige (elektrisch leitende) Verbindung von HTS-Bandleiter und SL-Folgeleiter kann beispielsweise durch Löten erfolgen; bevorzugt ist die Verbindung supraleitend.

Dadurch, dass der wesentliche Aufbau der Magnetspulensektion auf den Radialbereich RBS beschränkt ist, also bis auf eine Abweichung von maximal 20% (bevorzugt maximal 10%, besonders bevorzugt vollständig) innerhalb des durch den kleinsten Innenradius RiH des Spulenträgers im Hauptbereich und den größten Außenradius RaH des Hauptwickelpakets vorgegebenen Radiusintervalls liegt, kann eine hohe effektive supraleitende Stromdichte erreicht werden. Zudem sind dann erfindungsgemäße Magnetspulensektionen gut ineinander schachtelbar, um in Summe hohe Magnetfeldstärken zu erzeugen. Auch begrenzt verfügbare HTS-Bandleiter-Längen (z.B. von derzeit ca. 300 m) können in einer erfindungsgemäßen Magnetspulensektion effizient verbaut werden, wofür nur vergleichsweise geringe radiale Gesamtwandstärken der Magnetspulensektion benötigt werden. Dann können auf geringem Raum besonders viele Magnetspulensektionen geschachtelt werden.

Die zumindest im axial inneren Abschnitt des ersten und/oder zweiten Seitenbereichs verlaufenden nutenartigen Vertiefungen verlaufen typischerweise helixartig, mit variabler Steigung und (geringfügig) variablem Radius. Die nutenartigen Vertiefungen (und ggf. Jointnuten, Zuführungsnuten und Zwischenjointnuten, siehe unten) führen den HTS-Bandleiter mit sehr geringem Spiel (beispielsweise mit einem Spiel in Querrichtung ≤ 1/10 der Leiterbreite); der HTS-Bandleiter wird an jeder Windung einzeln gestützt.

Bevorzugt sind die nutenartigen Vertiefungen (und ggf. Jointnuten, Zuführungsnuten und Zwischenjointnuten, siehe unten) so ausgelegt, dass der HTS-Bandleiter ohne Biegung oder zumindest mit minimierter Biegung über die kurze Seite (also ohne oder mit minimiertem "hard bending") geführt wird. Man beachte, dass es bei gegebenem (dabei aber wählbarem), durch eine Mittellinie der Nut definiertem Nutverlauf genau eine zugeordnete abwickelbare Fläche, die so genannte Einhüllende der rektifizierenden Ebenen (vgl. Manfredo P. do Carmo, Differentialgeometrie von Kurven und Flächen, Vieweg Verlag, 1983, S. 240), gibt, die diese Bedingung erfüllt.

Typischerweise weist der erste SL-Folgeleiter eine niedrigere Sprungtemperatur auf als der HTS-Bandleiter, und der zweite SL-Folgeleiter weist eine niedrigere Sprungtemperatur auf als der HTS-Bandleiter. Insbesondere können der erste SL-Folgeleiter und der zweite SL-Folgeleiter von gleichem Typ (insbesondere vom gleichen SL-Material) sein. Die SL-Folgeleiter sind typischerweise metallisch duktil und dadurch leicht handhabbar; typischerweise ist der SL-Folgedraht ein NbTi-Draht. Mit den SL-Folgeleitern kann die weitere (externe) elektrische Anbindung der Magnetspulensektion erfolgen.

Im Rahmen der Erfindung ist es auch möglich, am ersten und/oder zweiten Joint zunächst (jeweils) den HTS-Bandleiter und den SL-Folgeleiter flächig zu verbinden ("Joint"), und sodann den SL-Folgeleiter wiederum mit einem SL-Drittleiter flächig zu verbinden ("Drittleiterjoint"), und dabei den SL-Folgeleiter und den SL-Drittleiter wiederum im Seitenbereich im axial äußeren Abschnitt auf dem Spulenträger aufzuwickeln. Insgesamt kann durch den Joint und den Drittleiterjoint ein so genannter Brückenjoint ("Bridgejoint") angelegt werden, wobei der SL-Folgeleiter als so genanntes Brückenband dient. Der SL-Drittleiter wird dann aus der Magnetspulensektion zur weiteren elektrischen Verbindung herausgeführt; für ihn gilt das ansonsten für den SL-Folgeleiter gesagte entsprechend.

Die Erfindung sieht vor, dass der erste Joint und der zweite Joint jeweils über den gesamten Umfang des Spulenträgers reichen, und/oder dass der erste Joint und der zweite Joint sich jeweils über eine Überlappungslänge, bezogen auf den HTS-Bandleiter, von wenigstens 0,1 m, bevorzugt wenigstens 0,5 m, erstrecken. Im Rahmen der Erfindung können problemlos große Überlappungsflächen bzw. Überlappungslängen eingerichtet werden. Dadurch können der erste und zweite Joint besonders zuverlässig mit hoher Stromtragfähigkeit und praktisch verschwindendem ohmschen Widerstand ausgebildet werden. Typischerweise reichen der erste und zweite Joint jeweils mit einer Vielzahl von Windungen, beispielsweise wenigstens 3 Windungen oder wenigstens 5 Windungen, um den Spulenträger herum, sowohl bezüglich des HTS-Bandleiters als auch bezüglich des SL-Folgeleiters. Man beachte, dass insbesondere bei Nutzung einer Jointwickelkammer die Zahl der Windungen des HTS-Bandleiters und des SL-Folgeleiters unterschiedlich sein können.

Bevorzugte Ausführungsformen der Erfindung

*Ausführungsformen zur Gestalt von erstem und zweitem Joint*

Bevorzugt ist eine Ausführungsform, bei der im Hauptbereich der Spulenträger eine umlaufende ringförmige Vertiefung als Hauptwickelkammer aufweist, in der das Hauptwickelpaket des HTS-Bandleiters in mehreren Lagen solenoidförmig aufgewickelt ist. Die Hauptwickelkammer ist leicht einzurichten, und kann die Windungen des HTS-Bandleiters axial umfassen und dadurch mechanisch stabilisieren. Bevorzugt fluchtet der obere (radial äußere) Rand der Vertiefung der Hauptwickelkammer im Spulenträger im Wesentlichen (z. B. mit einer maximalen Abweichung von 10%, bezogen auf RaH) mit der Oberseite (radialen Außenseite) des Hauptwickelpakets, so dass sich eine im Wesentlichen stufenlose Außenseite der Magnetspulensektion ergibt.

Eine bevorzugte Ausführungsform sieht vor, dass im axial äußeren Abschnitt des ersten Seitenbereichs der Spulenträger eine umlaufende ringförmige Vertiefung als erste Jointwickelkammer aufweist, in der zumindest der Teil des ersten Endabschnitts des HTS-Bandleiters mit mehreren nebeneinander liegenden Windungen und der Endabschnitt des ersten SL-Folgeleiters mit mehreren nebeneinander liegenden Windungen übereinander liegend aufgewickelt sind, und/oder dass im axial äußeren Abschnitt des ersten oder zweiten Seitenbereichs der Spulenträger eine umlaufende ringförmige Vertiefung als zweite Jointwickelkammer aufweist, in der zumindest der Teil des zweiten Endabschnitts des HTS-Bandleiters mit mehreren nebeneinander liegenden Windungen und der Endabschnitt des zweiten SL-Folgeleiters mit mehreren nebeneinander liegenden Windungen übereinander liegend aufgewickelt sind. Eine umlaufende Vertiefung als erste oder zweite Jointwickelkammer ist leicht einzurichten, und kann den Joint axial umfassen und dadurch mechanisch stabilisieren. Typischerweise sind der erste und zweite SL-Folgeleiter jeweils radial innen und der HTS-Bandleiter radial außen angeordnet, wobei der HTS-Bandleiter so orientiert ist, das dessen HTS-Schicht nach innen, also zum SL-Folgeleiter hin, zeigt. Typischerweise sind weiterhin die SL-Folgeleiter weniger breit als der HTS-Bandleiter, so dass im Verbindungsbereich (Überlappungsbereich) mehr Windungen des SL-Folgeleiters als Windungen des HTS-Bandleiters vorhanden sind.

Bei einer vorteilhaften Weiterentwicklung ist der Spulenträger im Bereich der Wände der ersten Jointwickelkammer und/oder der Wände der zweiten Jointwickelkammer aus einem elektrisch isolierenden Material, insbesondere einem Kunststoff, ausgebildet. Dies kann beispielsweise dadurch eingerichtet werden, dass der Spulenträger im Bereich der Jointwickelkammer mit einem Kunststoffrohr oder Kunststoffschalen gefertigt ist, das oder die bei der Fertigung des Spulenkörpers in den ansonsten metallischen Spulenträger (Grundkörper) integriert wurde(n). Die elektrische Isolation der Wickelkammer verhindert Kurzschlussströme zwischen den Leitern und dem metallischen Spulenträger und Ströme über diesen zwischen den Joints.

Vorteilhaft ist auch eine Ausführungsform, die vorsieht,

dass im axial äußeren Abschnitt des ersten Seitenbereichs der Spulenträger eine erste Jointnut aufweist, die wenigstens einmal, bevorzugt mehrfach, um den Spulenträger führt, und in der zumindest der Teil des ersten Endabschnitts des HTS-Bandleiters und der Endabschnitt des ersten SL-Folgeleiters übereinander liegend geführt sind, und/oder dass im axial äußeren Abschnitt des ersten oder zweiten Seitenbereichs der Spulenträger eine zweite Jointnut aufweist, die wenigstens einmal, bevorzugt mehrfach, um den Spulenträger führt, in der zumindest der Teil des zweiten Endabschnitts des HTS-Bandleiters und der Endabschnitt des zweiten SL-Folgeleiters übereinander liegend geführt sind.

Durch die Jointnut kann eine sehr genaue Führung des HTS-Bandleiters und des SL-Folgeleiters erfolgen, etwa um die mechanische Belastung durch Kräfte (insbesondere Lorenzkräfte) zu minimieren und/oder die Ausrichtung in Hinblick auf die Stromtragfähigkeit zu optimieren. In der jeweiligen Jointnut verlaufen "ein" HTS-Bandleiter und "ein" SL-Folgeleiter gemeinsam um den Spulenträger; die Jointnut verläuft typischerweise helixförmig.

Bevorzugt ist eine Weiterbildung dieser Ausführungsform, bei der der Spulenträger im Bereich der Wände der ersten Jointnut und/oder der Wände der zweiten Jointnut aus einem elektrisch isolierenden Material, insbesondere einem Kunststoff, ausgebildet ist. Dadurch können Kurzschlussringe im Bereich des jeweiligen Joints vermieden werden.

*Ausführungsformen mit erstem und zweitem Joint auf einer Seite*

Besonders bevorzugt ist eine Ausführungsform, bei der in dem ersten Seitenbereich auch der zweite Endabschnitt des HTS-Bandleiters auf den Spulenträger aufgewickelt ist, insbesondere wobei im axial inneren Abschnitt des ersten Seitenbereichs die nutenartigen Vertiefungen des ersten Endabschnitts und des zweiten Endabschnitts sich mehrfach kreuzen.

Durch Ausbildung des ersten und zweiten Joints im ersten Seitenbereich, also auf derselben (axialen) Seite des Hauptbereichs bzw. der Hauptwickelkammer, kann ein besonders kompakter Aufbau erreicht werden, denn der axial innere Abschnitt des ersten Seitenbereichs kann dann dazu genutzt werden, sowohl den ersten Joint als auch den zweiten Joint vom Hauptbereich entfernt im niedrigen Magnetfeld anzuordnen. Zudem können externe elektrische Verbindungen (mittels der SL-Folgeleiter) auf einer Seite konzentriert werden, wodurch der Zugang in einem Kryostaten von nur einer Seite (etwa von oben) begünstigt ist; ein Zugang von nur einer Seite ist bei einem vertikalen Magentaufbau der Regelfall. Durch das Gestatten von Kreuzungen wird die Führung des HTS-Bandleiters erheblich vereinfacht; insbesondere kann eine zu schnelle Änderung der Steigung der (helixartigen) Wicklungen der HTS-Bandleiter vom Hauptbereich weg vermieden werden und damit die Biegung des HTS-Bandleiters um die kurze Seite minimiert oder ganz eliminiert werden. Alternativ zu dieser Ausführungsform können auch der erste Endabschnitt und der zweite Endabschnitt des HTS-Bandleiters auf unterschiedlichen Seitenbereichen aufgewickelt sein.

Bevorzugt ist eine Weiterbildung dieser Ausführungsform, die vorsieht, dass der Spulenträger in einem axial an die Hauptwickelkammer anschließenden Übergangsbereich des axial inneren Abschnitts des ersten Seitenbereichs mit einem Satz von Trägerschalen ausgebildet ist, die auf dem übrigen Spulenträger aufliegen und zusammen den übrigen Spulenträger ringförmig umgreifen,

und dass im Übergangsbereich eine der nutenartigen Vertiefungen für den ersten Endabschnitt und den zweiten Endabschnitt des HTS-Bandleiters in dem Satz von Trägerschalen ausgebildet ist, und die andere der nutenartigen Vertiefungen für den ersten Endabschnitt und den zweiten Endabschnitt des HTS-Bandleiters radial unter dem Satz von Trägerschalen im übrigen Spulenträger ausgebildet ist, wobei in dem Übergangsbereich der erste und zweite Endabschnitt des HTS-Bandleiters sich wenigstens einmal kreuzen. Meist umfasst das Hauptwickelpaket wenigstens 4 Wickellagen, oft auch wenigstens 10 oder wenigstens 40 Wickellagen, so dass am Eingang und Ausgang des Hauptwickelpakets ein erheblicher Radiusunterschied der Endabschnitte des HTS-Bandleiters vorhanden ist. Der Endabschnitt der HTS-Bandleiters in der radial äußeren nutenartigen Vertiefung kann auf den Trägerschalen mechanisch stabil aufliegen, auch wenn der andere Endabschnitt des HTS-Bandleiters radial deutlich weiter innen im (übrigen) Spulenträger (Grundkörper) verläuft und bei geringer Ganghöhe über einen erheblichen Anteil des Umfangs des Spulenträgers, z.B. wenigstens den halben Umfang, überkreuzt (überlappt) werden muss. Typischerweise steigt der Radius der radial inneren nutenartigen Vertiefung im übrigen Spulenträger im Übergangsbereich nach axial außen hin an, um den zugehörigen Endabschnitt des HTS-Bandleiters zur Außenseite des Spulenträgers zu führen. Typischerweise werden zwei Trägerschalen ("Halbschalen") als Satz eingesetzt.

Bei einer anderen bevorzugten Weiterbildung sind im axial inneren Abschnitt des ersten Seitenbereichs die nutenartigen Vertiefungen für den ersten Endabschnitt und den zweiten Endabschnitt des HTS-Bandleiters in wenigstens einem Kreuzungsbereich der nutenartigen Vertiefungen mit einer unterschiedlichen Nutentiefe ausgebildet. Durch die Einrichtung der Kreuzungsbereiche kann eine größere Freiheit bei der Führung der beiden Endabschnitte des HTS-Bandleiters erhalten werden, insbesondere um mechanische Belastungen zu minimieren, etwa die Biegung um die kurze Seite. Bevorzugt entspricht der Unterschied in der Nutentiefe mindestens der Höhe des HTS-Bandleiters, so dass die Endabschnitte des HTS-Bandleiters im Kreuzungsbereich stabil aneinander vorbei geführt werden.

Bevorzugt ist eine Weiterbildung, bei der im axial äußeren Abschnitt des ersten Seitenbereichs eine nutenartige Vertiefung für denjenigen Endabschnitt des HTS-Bandleiters, welcher den axial weiter außen liegenden Joint aufweist, radial innerhalb des axial weiter innen liegenden Joints verläuft. Dieser Aufbau ist einfach und nutzt den im Spulenkörper verfügbaren Bauraum in günstiger Weise aus.

Ebenso bevorzugt ist eine Weiterbildung, bei der im axial äußeren Abschnitt des ersten Seitenbereichs eine Ausleitungsnut für denjenigen SL-Folgeleiter, der Teil des axial weiter innen liegenden Joints ist, radial innerhalb des axial weiter außen liegenden Joints verläuft. Dieser Aufbau ist wiederum einfach und nutzt den im Spulenkörper verfügbaren Bauraum in günstiger Weise aus.

*Ausführungsformen mit Zwischenjoint, insbesondere Bottomjoint*

Bevorzugt ist weiterhin eines Ausführungsform einer erfindungsgemäßen Magnetspulensektion, bei der der HTS-Bandleiter wenigstens zwei HTS-Teilbänder aufweist, die seriell über wenigstens einen Zwischenjoint leitend miteinander verbunden sind,

wobei die HTS-Teilbänder im Bereich des wenigstens einen Zwischenjoints im ersten Seitenbereich oder im zweiten Seitenbereich auf dem Spulenträger aufgewickelt sind,

insbesondere wobei im Bereich des wenigstens einen Zwischenjoints die HTS-Teilbänder mit einem gemeinsamen Supraleiter(=SL)-Brückenband verbunden sind. Durch die Verwendung der HTS-Teilbänder kann die gesamte nutzbare Länge von HTS-Bandleiter in der Magnetspulensektion gegenüber der verfügbaren (fehlerfrei fertigbaren) Länge von HTS-Bandleiter-Stücken vergrößert werden. Bevorzugt bildet der Zwischenjoint ein HTS-HTS-Joint aus; es ist aber auch möglich, den Zwischenjoint axial vom Hauptwickelpaket ausreichend entfernt anzuordnen, so dass beispielsweise auch ein SL-Brückenband aus LTS-Material genutzt werden kann.

Eine bevorzugte Weiterbildung dieser Ausführungsform sieht vor, dass der Spulenträger im ersten Seitenbereich oder im zweiten Seitenbereich zwei Zuführungsnuten für die HTS-Teilbänder ausbildet, die von der Hauptwickelkammer zum Bereich des wenigstens einen Zwischenjoints führen, und der Spulenträger im Bereich des Zwischenjoints eine Zwischenjointnut für die HTS-Teilbänder ausbildet. In den Zuführungsnuten und der Zwischenjointnut kann der HTS-Bandleiter an jeder einzelnen Windung gestützt und geführt werden, insbesondere in Hinblick auf eine minimierte Biegung über die kurze Seite des HTS-Bandleiters und eine günstige Orientierung zum Magnetfeld.

Bevorzugt ist dabei vorgesehen, dass der Spulenträger im Bereich des wenigstens einen Zwischenjoints mit einem Satz von Trennschalen ausgebildet ist, die auf dem übrigen Spulenträger aufliegen und zusammen den übrigen Spulenträger ringförmig umgreifen,

und dass ein radial äußerer Teil der Zwischenjointnut in dem Satz von Trennschalen ausgebildet ist, und ein radial innerer Teil der Zwischenjointnut radial unter dem Satz von Trennschalen im übrigen Spulenträgerausgebildet ist, insbesondere wobei der Satz von Trennschalen einen Bereich für den Radiuswechsel des Zwischenjoints aufweist. Mittels der Trennschalen ist es möglich, die Zwischenjointnut mit zwei übereinander liegenden Lagen auszubilden, so dass der Zwischenjoint in axialer Richtung hin- und zurückführend über denselben axialen Bereich gewickelt werden kann. Typischerweise werden zwei Trennschalen ("Halbschalen") als Satz eingesetzt. Der Bereich für den Radiuswechsel kann insbesondere einen Durchführungsschlitz in dem Satz von Trennschalen aufweisen.

Bei einer anderen Weiterbildung ist vorgesehen, dass in dem ersten Seitenbereich auch der zweite Endabschnitt des HTS-Bandleiters auf den Spulenträger aufgewickelt ist, und die HTS-Teilbänder im Bereich des wenigstens einen Zwischenjoints im zweiten Seitenbereich auf dem Spulenträger aufgewickelt sind, insbesondere wobei der Spulenträger mit seiner Zylinderachse vertikal sowie dem zweiten Seitenbereich unten und dem ersten Seitenbereich oben ausgerichtet ist. Diese Bauform vereinfacht die Führung des HTS-Bandleiters. Zudem ist der Aufbau sehr kompakt.

*Diverse Ausführungsformen*

Bei einer vorteilhaften Ausführungsform ist vorgesehen, dass

- die nutenartigen Vertiefungen, in denen der HTS-Bandleiter zumindest im axial innen liegenden Abschnitt des ersten und/oder zweiten Seitenbereichs geführt sind,
- und gegebenenfalls Jointnuten, in denen die ersten und/oder zweiten Endabschnitte des HTS-Bandleiters im axial äußeren Abschnitt des ersten und/oder zweiten Seitenbereichs geführt sind,
- und gegebenenfalls Zuführungsnuten und Zwischenjointnuten für mit einem Zwischenjoint verbundene HTS-Teilbänder des HTS-Bandleiters,

zumindest teilweise mit einem Nutgrund ausgebildet sind, auf dem der HTS-Bandleiter aufliegt und dessen lokale Flächennormale einen von 90° abweichenden Winkel zur Achse des Spulenträgers aufweist. Durch diese Bauform (mit "verkipptem Nutgrund") kann ein Winkel zwischen der lokalen Magnetfeldrichtung des vom Hauptwickelpaket erzeugten Magnetfelds (oder einem insgesamt von einer Magnetanordnung erzeugten Magnetfelds, zu dem die Magnetspulensektion gehört) und der lokalen Bandebene des HTS-Bandleiters minimiert werden, wodurch die supraleitende Stromtragfähigkeit verbessert wird. Zudem kann durch die Ausbildung des Nutgrunds der HTS-Bandleiter so geführt werden, dass die Biegung über die kurze Seite ("hard bending") minimiert oder eliminiert wird.

Weiterhin bevorzugt ist eine Ausführungsform, die vorsieht,

dass der erste SL-Folgeleiter und/oder der zweite SL-Folgeleiter ein Tieftemperatursupraleiter(=LTS)-Material, insbesondere NbTi, enthalten,
und/oder dass der erste SL-Folgeleiter und/oder der zweite SL-Folgeleiter $MgB_2$ enthalten,
und/oder dass der HTS-Bandleiter ReBCO, insbesondere YBCO, oder Bi2223 enthält.

Diese Bauformen sind in der Praxis bewährt; zugehörige Leitermaterialien sind kommerziell verfügbar. Re steht für ein seltenes Erdelement. Eine typische Breite des HTS-Bandleiters beträgt 2,5-10 mm, meist 4 mm. Der HTS-Bandleiter weist meist ein (flexibles) Substrat aus Edelstahl oder Hastelloy auf. Die SL-Folgeleiter sind typischerweise als duktiler Draht ausgebildet, bevorzugt mit einem rechteckigen Drahtquerschnitt. Die HTS-Materialien haben typischerweise eine Sprungtemperatur oberhalb von 40 K. Die LTS-Materialien haben typischerweise eine Sprungtemperatur unterhalb von 30 K.

Vorteilhaft ist auch eine Ausführungsform, bei der im ersten Seitenbereich der HTS-Bandleiter des ersten Endabschnitts und im ersten oder zweiten Seitenbereichs der HTS-Bandleiter des zweiten Endabschnitts jeweils helixförmig gewickelt sind, mit einer nach axial außen hin zunächst zunehmenden und dann wieder abnehmenden Ganghöhe. Die zunächst zunehmende Ganghöhe vereinfacht die Minimierung der Biegung über die kurze Seite des HTS-Bandleiters. Die wieder zurückgehende Ganghöhe erleichtert den Übergang in den Bereich des auf dem Spulenkörper gewickelten ersten und zweiten Joints, wiederum bei vereinfachter Minimierung des Biegens über die kurze Seite des HTS-Bandleiters. Mit der im mittleren Bereich hohen Ganghöhe kann die Gesamtlänge an HTS-Bandleiter zwischen Hauptwickelkammer und Joint minimiert werden, auch um die Magnetfeldhomogenität im Probenvolumen zu verbessern.

Bevorzugt ist eine Ausführungsform, bei der der erste SL-Folgeleiter und der zweite SL-Folgeleiter jeweils mit einem Verbindungsabschnitt vom axial äußeren Abschnitt des ersten oder zweiten Seitenbereichs axial weg führen. Dies ermöglicht eine weitere platzsparende elektrische Verschaltung, insbesondere im Falle von geschachtelten Magnetspulenanordnungen.

*Magnetanordnungen mit geschachtelten Magnetspulensektionen*

In den Rahmen der vorliegenden Erfindung fällt auch eine Magnetanordnung, umfassend mehrere erfindungsgemäße, oben beschriebene Magnetspulensektionen, wobei die Magnetspulensektionen ineinander geschachtelt angeordnet sind, insbesondere wobei für eine über den gesamten Umfang gemittelte Spaltbreite MS eines jeweiligen radialen Spalts zwischen benachbarten Magnetspulensektionen gilt: MS ≤ 1 mm, bevorzugt MS ≤ 0,5 mm. Typischerweise gilt auch für eine größte, über den gesamten Umfang auftretende Spaltbreite GSB eines jeweiligen radialen Spalts zwischen benachbarten Magnetspulensektionen, dass GSB ≤ 1 mm, bevorzugt GSB ≤ 0,6 mm, besonders bevorzugt GSB ≤ 0,45 mm. Durch die geschachtelte Anordnung von Magnetspulensektion kann eine große absolute Magnetfeldstärke in einem Probenvolumen innerhalb der innersten Magnetspulensektion erreicht werden. Durch den Aufbau der Magnetspulensektionen mit einer geringen Spaltbreite zwischen den Magnetspulensektionen kann eine hohe effektive supraleitende Stromdichte (engineering current density) erreicht werden.

Bei einer vorteilhaften Ausführungsform der erfindungsgemäßen Magnetanordnung ist vorgesehen,

dass das Hauptwickelpaket einer jeweiligen radial inneren Magnetspulensektion radial nach außen hin an einer Innenseite des Spulenträgers der radial nächst äußeren Magnetspulensektion anliegt,
oder dass ein jeweiliger radialer Spalt zwischen benachbarten Magnetspulensektionen mit einem Füllmaterial verfüllt ist, insbesondere wobei das Füllmaterial elektrisch isolierend ist, und insbesondere wobei das Füllmaterial ein ausgehärtetes Gussmaterial und/oder Folien umfasst. Durch das gegenseitige direkte radiale Anliegen und/oder die Verfüllung des radialen Spalts kann eine gegenseitige mechanische Stabilisierung ("Korsettstruktur") erreicht werden. Durch die gegenseitige radiale mechanische Abstützung (direkt oder über die Verfüllung des Spaltes) werden Leiterbeschädigungen verhindert und Inhomogenitäten des im Probenvolumen erzeugten Magnetfelds minimiert. Wird die Korsettwirkung der gegenseitigen radialen Abstützung genutzt, können auch vergleichsweise dünne HTS-Bandleiter eingesetzt werden, die selbst eine eher geringe mechanische Festigkeit (insbesondere Zugfestigkeit) haben, aber mit denen eine höhere effektive Stromdichte erreicht werden kann. Alternativ oder zusätzlich können das Hauptwickelpaket und/oder weitere Bereiche des HTS-Bandleiters mit einem Korsettband oder Korsettdraht umwickelt werden.

Bevorzugt ist auch eine Ausführungsform, bei der die Magnetspulensektionen mit einer identischen axialen Länge der Spulenträger ausgebildet sind und die Spulenträger axial fluchten. Dadurch wird ein in axialer Richtung kompakter und gut zu handhabender Aufbau erreicht, der gut in einem Kryostaten untergebracht werden kann.

Besonders bevorzugt ist eine Ausführungsform, bei der die Magnetspulensektionen über ihre ersten SL-Folgeleiter und zweiten SL-Folgeleiter leitend miteinander verbunden sind. Typischerweise werden die Spulensektionen elektrisch in Serie miteinander verbunden. Über die SL-Folgeleiter ist eine elektrische, insbesondere supraleitende Verbindung leicht möglich, wobei diese Verbindung im Niederfeldbereich angeordnet werden kann. Falls die Magnetanordnung weitere Magnetspulensektionen (über die oben beschriebenen Magnetspulensektionen mit integrierten Joints hinaus) umfasst, werden diese typischerweise in die elektrische Serienschaltung einbezogen. Alternativ ist es auch möglich, einzelne oder mehrere Spulensektionen separat zu betreiben, etwa eine radial äußerste Magnetspulensektion, die für eine aktive Magnetfeldabschirmung eingesetzt wird.

Vorteilhaft ist weiterhin eine Ausführungsform, bei der die Magnetanordnung dazu ausgebildet ist, in einem Probenvolumen von wenigstens 0,5 cm$^3$ im Inneren der innersten Magnetspulensektion ein Magnetfeld einer Stärke B0 und einer Homogenität von 100 ppm oder besser zu erzeugen, und dass die ersten Joints und zweiten Joints, und bevorzugt auch gegebenenfalls der oder die Zwischenjoints, der Magnetspulensektionen axial so weit vom Probenvolumen beabstandet angeordnet sind, dass für die größte Magnetfeldstärke Bjoint an jedem dieser Joints betragsmäßig gilt:

$$Bjoint \leq 1/2 \cdot B0,$$

$$\text{bevorzugt } Bjoint \leq 1/10 \cdot B0,$$

$$\text{besonders bevorzugt } Bjoint \leq 1/50 \cdot B0,$$

insbesondere wobei B0 ≥ 20 T ist. Die geringe Magnetfeldstärke Bjoint kann durch das axiale Herausführen gegenüber dem Hauptwickelpaket im Rahmen der Erfindung leicht eingerichtet werden. Durch die geringe Magnetfeldstärke Bjoint kann eine hohe Stromtragfähigkeit des jeweiligen Joints erreicht werden, bevorzugt so, dass der jeweilige Joint die supraleitende Stromtragfähigkeit der Magnetanordnung insgesamt nicht begrenzt.

Bevorzugt ist zudem eine Ausführungsform einer erfindungsgemäßen Magnetanordnung, wobei wenigstens eine der Magnetspulensektionen mit einem verkippten Nutgrund (siehe oben) ausgebildet ist, wobei die Magnetanordnung vorsieht, dass die Magnetspulensektionen elektrisch in Serie geschaltet sind, und dass die lokale Flächennormale des Nutgrunds so verläuft, dass

- ein Biegen über die kurze Kante des auf dem Nutgrund aufliegenden HTS-Bandleiters so klein ist, dass eine Dehnung des HTS-Bandleiters auch an dessen Rändern nirgends 0,6% überschreitet, bevorzugt nirgends 0,2% überschreitet, besonders bevorzugt dass kein Biegen über die kurze Kante des auf dem Nutgrund aufliegenden HTS-Bandleiters erfolgt, und gleichzeitig
- eine lokale Normalkomponente eines durch die Magnetanordnung insgesamt erzeugten Magnetfelds, welche parallel zur lokalen Flächennormalen des Nutgrunds liegt, betragsmäßig überall kleiner oder gleich ist einer Referenz-Normalkomponente des Magnetfelds, die am HTS-Bandleiter in den axial äußersten Windungen des Hauptwickelpakets senkrecht zur lokalen Bandebene des HTS-Bandleiters maximal vorliegt. Mit anderen Worten, der Nutgrund ist so geführt und ausgerichtet, dass die maximale lokale Normalkomponente MNK des Magnetfelds am Nutgrund kleiner oder gleich ist der Referenz-Normalkomponente RNK, die ohnehin im Hauptwickelpaket (an dessen axialem Rand) auftritt. Dann begrenzt die Normalkomponente entlang des Nutgrunds die Stromtragfähigkeit der Magnetanordnung insgesamt nicht. Typischerweise ist bei allen Magnetspulensektionen der Magnetanordnung ein verkippter Nutgrund vorgesehen, bei dem MNK≤RNK gilt.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Detaillierte Beschreibung der Erfindung und Zeichnung

Fig. 1    zeigt einen schematischen Längsschnitt durch eine Ausführungsform der erfindungsgemäßen Magnetspulensektion, mit dem ersten und zweiten Joint im oberen, ersten Seitenbereich und einem Zwischenjoint im unteren, zweiten Seitenbereich;

Fig. 2a    zeigt eine schematische Perspektivansicht der Magnetspulensektion von Fig. 1, im oberen, ersten Seitenbereich im Bereich des ersten und zweiten Joints der Magnetspulensektion;

Fig. 2b    zeigt die schematische Perspektivansicht von Fig. 2a, ohne den Spulenträger;

Fig. 3a    zeigt eine schematische Perspektivansicht der Magnetspulensektion von Fig. 1 im Übergangsbereich vom oberen Ende des Hauptwickelpakets zum unteren (axial inneren) Teil des ersten Seitenbereichs, mit dem Grundkörper und dem ersten Endbereich des HTS-Bandleiters und ohne den Satz von Trägerschalen;

Fig. 3b    die Perspektivansicht von Fig. 3a, mit dem Grundkörper sowie dem ersten Endbereich und dem zweiten Endbereich des HTS-Bandleiters und dem Satz von Trägerschalen;

Fig. 3c    die Perspektivansicht von Fig. 3a, nur mit den beiden Endabschnitten des HTS-Bandleiters;

Fig. 3d    die Perspektivansicht von Fig. 3a, nur mit dem Satz von Trennschalen;

Fig. 4a    zeigt eine schematische Perspektivansicht der Magnetspulensektion von Fig. 1 im zweiten, unteren Seitenbereich, im Bereich vom unteren axialen Ende des Hauptwickelpakets bis zum Zwischenjoint;

Fig. 4b    zeigt die Perspektivansicht von Fig. 4a, aber nur die HTS-Teilbänder;

Fig. 4c    zeigt die Perspektivansicht von Fig. 4a, aber nur den Satz von Trennschalen;

Fig. 4d    zeigt die Perspektivansicht von Fig. 4a, aber nur den Spulenträger ohne Trennschalen im Bereich des Zwischenjoints;

Fig. 5    zeigt eine schematische Perspektivansicht der Magnetspulensektion von Fig. 1, im Bereich vom Hauptwickelpaket bis zum ersten Joint, nur mit dem ersten Endabschnitt des HTS-Bandleiters;

Fig. 6    zeigt einen stark schematisierten Längsschnitt durch eine Ausführungsform einer erfindungsgemäßen Magnetanordnung, umfassend mehrere geschachtelt angeordnete Magnetspulensektionen;

Fig. 7    zeigt einen stark schematisierten Längsschnitt durch eine weitere Ausführungsform einer erfindungsgemäßen Magnetspulensektion, mit dem ersten Joint im ersten Seitenbereich und dem zweiten Joint gegenüberliegend im zweiten Seitenbereich;

Fig. 8    zeigt einen stark schematischen Längsschnitt durch eine weitere Ausführungsform einer erfindungsgemäßen Magnetspulensektion, beschränkt auf den ersten Seitenbereich, mit einer Jointnut für den ersten Joint im ersten Seitenbereich.

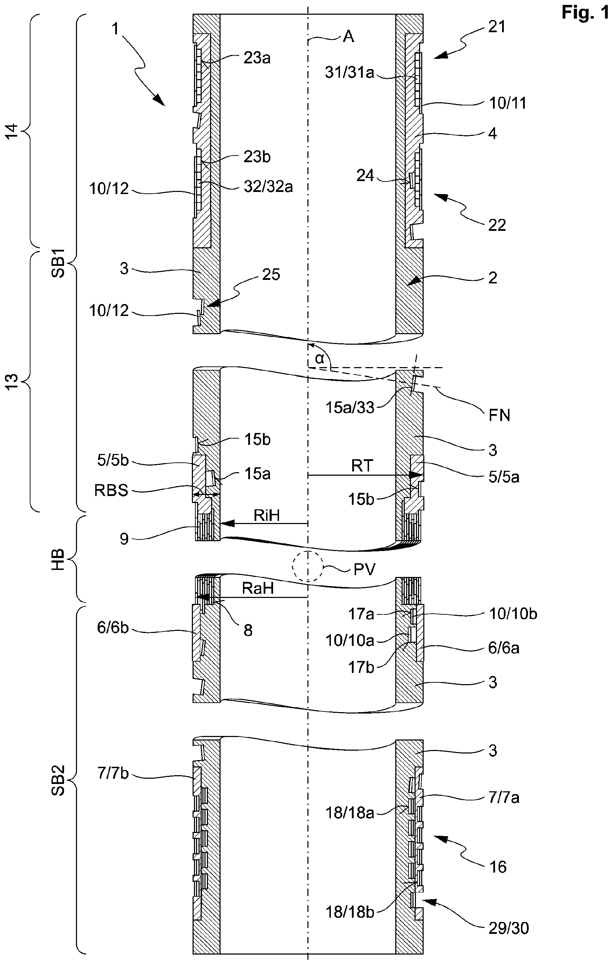

Die **Fig. 1** zeigt in einer schematischen Längsansicht eine Ausführungsform einer erfindungsgemäßen Magnetspulensektion 1.

Die Magnetspulensektion 1 verfügt über einen Spulenträger 2, der insgesamt im Wesentlichen zylindermantelförmig aufgebaut ist, vgl. die Achse (Zylinderachse) A des Spulenträgers 2, und größtenteils mit einem rohrförmigen Grundkörper 3, hier aus Stahl, ausgebildet ist. Zudem verfügt der Spulenträger 2 hier über einen Isolationskörper 4, einen Satz 5 von Trägerschalen 5a, 5b, einen Satz 6 von Flanschelementen 6a, 6b und einen Satz 7 von Trennschalen 7a, 7b, die auf dem Grundkörper 3 aufsitzen.

Weiterhin verfügt die Magnetspulenanordnung 1 über einen HTS-Bandleiter 10, der hier zweiteilig mit einem ersten HTS-Teilband 10a und einem zweiten HTS-Teilband 10b ausgebildet ist. Der HTS-Bandleiter 10 ist hier mit einer YBCO-Schicht auf einem flexiblen Metallsubstrat, hier aus Stahl, ausgebildet. Zudem verfügt die Magnetspulensektion 1 über zwei SL-Folgeleiter 31, 32. Die beiden SL-Folgeleiter 31, 32 sind hier als NbTi-Drähte ausgebildet.

Der HTS-Bandleiter 10 verfügt über einen ersten Endbereich 11, der im Bereich eines ersten Joints 21 mit einem Endbereich 31a des ersten SL-Folgeleiters 31 verbunden ist. Weiterhin verfügt der HTS-Bandleiter 10 über einen zweiten Endbereich 12, der im Bereich eines zweiten Joints 22 mit einem Endbereich 32a des zweiten SL-Folgeleiter 32 verbunden ist.

Die Magnetspulensektion 1 ist in der schematischen Darstellung teilweise unterbrochen dargestellt (vgl. wellenartige Stöße), um die wesentlichen Aspekte der Erfindung besser darstellen zu können. Der größte Teil des HTS-Bandleiters 10 ist in einem axial mittig gelegenen Hauptbereich HB des Spulenkörpers 2 in einer Hauptwickelkammer 8 zu einem Hauptwickelpaket 9 solenoidförmig in mehreren Lagen, hier acht Lagen, aufgewickelt. Man beachte, dass die axiale Länge der Hauptwickelkammer 9 in Fig. 1 stark verkürzt widergegeben ist. Wird der HTS-Bandleiter 10 von elektrischem Strom durchflossen, wird (typischerweise ergänzt durch die Wirkung weiterer Magnetspulensektionen) in einem Probenvolumen PV im Inneren der Magnetspulensektion 1 ein Magnetfeld erzeugt, das beispielsweise für NMR-Messungen genutzt werden kann.

An den Hauptbereich HB schließt sich axial oben ein erster Seitenbereich SB1 an, in welchem auch die beiden Joints 21, 22 ausgebildet sind. In einem axial inneren Abschnitt 13 werden dabei die Endabschnitte 11, 12 des HTS-Bandleiters 10 von den Joints 21, 22 zum Hauptbereich HB in nutenartigen Vertiefungen 15a, 15b, die helixartig verlaufen, überführt. In einem axial äußeren Abschnitt 14 sind die Joints 21, 22 ausgebildet. Im Bereich der Joints 21, 22 sind die Endabschnitte 11, 12 des HTS-Bandleiters 10 und Endabschnitte 31a, 32a der SL-Folgeleiter 31, 32 in Jointwickelkammern 23a, 23b übereinanderliegend auf dem Spulenträger 2 aufgewickelt.

An den Hauptbereich HB schließt sich nach axial unten ein zweiter Seitenbereich SB2 an, in welchem ein Zwischenjoint 16 ausgebildet ist. Aufgrund seiner in der gezeigten Ausführungsform unteren Lage wird der Zwischenjoint 16 auch als Bodenjoint ("Bottomjoint") bezeichnet.

Dabei führen Zuführungsnuten 17a, 17b für die HTS-Teilbänder 10a, 10b im Spulenkörper 2 von der Hauptwickelkammer 8 zum Zwischenjoint 16, wo die HTS-Teilbänder 10a, 10b in einer Zwischenjointnut 18 aufeinanderliegend und elektrisch verbunden auf dem Spulenträger 2 aufgewickelt sind.

Die Magnetspulensektion 1 nutzt für den Spulenträger 2, den HTS-Bandleiter 10 und die SL-Folgeleiter 31, 32 zumindest im Bereich der Joints 21, 22 (also ggf. ohne ausgreifende Verbindungsbereiche der SL-Folgeleiter 31, 32) in radialer Richtung als Bauraum einen Radialbereich RBS aus, der hier vom kleinsten Innenradius RiH des Spulenträgers 2 im Hauptbereich HB (wobei in der Ausführungsform der Innenradius des Spulenträgers 2 überall gleich ist) bis zum Außenradius RT der Trägerschalen 5a, 5b reicht; diese Trägerschalen 5a, 5b sind hier die am weitesten radial ausgreifenden Teile des Spulenträgers 2. Der Außenradius RT der Trägerschalen 5a, 5b ist dabei geringfügig größer als der größte Außenradius RaH des Hauptwickelpakets 9 des HTS-Bandleiters 10, hier mit ca. RT=1,03*RaH.

Durch die Beabstandung der Joints 21, 22 und des Zwischenjoints 16 in axialer Richtung vom Hauptwickelpaket 9 kann sichergestellt werden, dass die größte Magnetfeldstärke Bjoint an diesen drei Joints 21, 22, 16 betragsmäßig erheblich keiner ist als die (homogene) Magnetfeldstärke B0 im Probenvolumen PV. Zudem sind durch das Aufwickeln des HTS-Bandleiters 10 an diesen drei Joints 21, 22, 16 auf dem Spulenträger 2 diese Joints 21, 22, 16 räumlich besonders kompakt untergebracht, und diese drei Joints 21, 22, 16 können mit großer Überlappungslänge oder Überlappungsfläche zuverlässig und mit praktisch vernachlässigbarem ohmschen Widerstand ausgeführt werden.

Im Folgenden werden die Merkmale der Magnetspulensektion 1 anhand von weiteren Figuren, die die Fig. 1 ergänzen und detaillieren, näher ausgeführt.

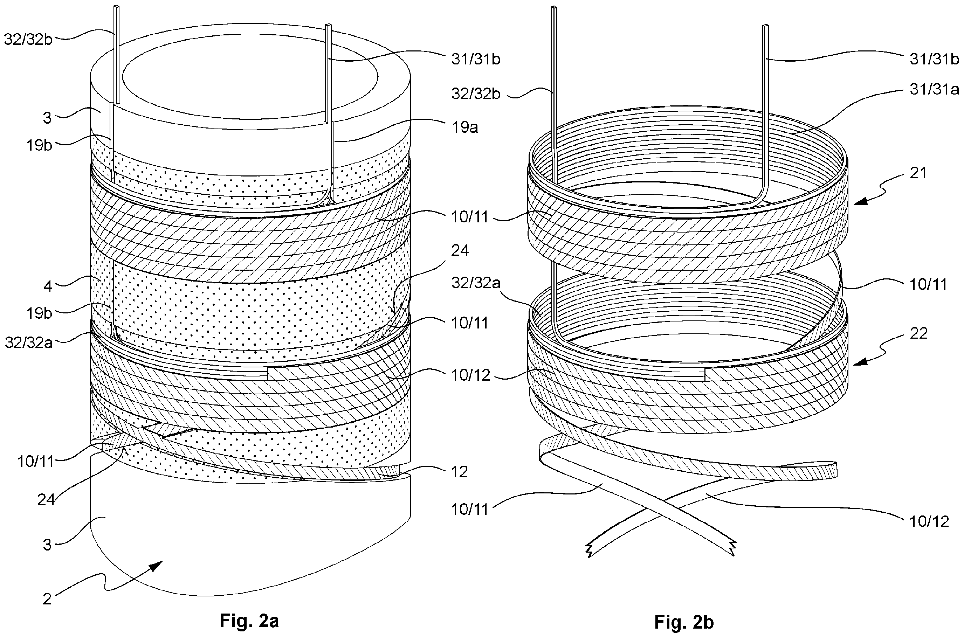

Die **Figuren 2a und 2b** illustrieren die Joints 21, 22 näher. Im Bereich des oberen, ersten Joints 21 ist radial innen der erste SL-Folgeleiter 31 mit dem Endabschnitt 31a auf dem Isolationskörper 4 (der im Wesentlichen als ein Kunststoffrohr ausgebildet ist) aufgewickelt. Ein Verbindungsabschnitt 31b des ersten SL-Folgeleiters 31 führt in axialer Richtung weg, wofür im Spulenträger 2 eine Ausleitungsnut 19a ausgebildet ist. Hier radial außen auf dem ersten SL-Folgeleiter 31 ist ein Teil des ersten Endabschnitt 11 des HTS-Bandleiters 10 aufgewickelt und elektrisch leitend (bevorzugt supraleitend) und flächig miteinander verbunden. Die Überlappungslänge, bezogen auf den HTS-Bandleiter, entspricht hier ca. 3-4 Windungen. Im Isolationskörper 4 ist eine umlaufende Vertiefung als Jointwickelkammer 23a ausgebildet (in Fig. 1 besser zu sehen), in der der aufgewickelte erste Endabschnitt 11 des HTS-Bandleiters 10 und der aufgewickelte Endabschnitt 31a des ersten SL-Folgeleiters 31 untergebracht sind. Da der Isolationskörper 4 aus elektrisch isolierendem Material, etwa Kunststoff, gefertigt ist, sind damit die Wände der Jointwickelkammer 23a elektrisch isolierend.

Unter dem ersten Joint 21 bzw. unter der Jointwickelkammer 23a führt ein Verbindungsabschnitt 32b des zweiten SL-Folgeleiters 32 in einer Ausleitungsnut 19b hindurch.

Der zweite SL-Folgeleiter 32 ist ebenfalls mit seinem Endabschnitt 32a auf dem Isolationskörper 4 aufgewickelt. Der Verbindungsabschnitt 32b des zweiten SL-Folgeleiters 32 führt axial nach oben weg. Wiederum hier radial außen auf dem zweiten SL-Folgeleiter 32 ist ein Teil des zweiten Endabschnitts 12 des HTS-Bandleiters 10 aufgewickelt und elektrisch leitend (bevorzugt supraleitend) und flächig miteinander verbunden. Die Überlappungslänge, bezogen auf den HTS-Bandleiter 10, entspricht hier ca. 3-4 Windungen. Im Isolationskörper 4 ist eine umlaufende Vertiefung als Jointwickelkammer 23b ausgebildet (in Fig. 1 besser zu sehen), in der der aufgewickelte zweite Endabschnitt 12 des HTS-Bandleiters 10 und der aufgewickelte Endabschnitt 32a des zweiten SL-Folgeleiters 32 untergebracht sind. Die Jointwickelkammer 23b bildet aufgrund ihrer Ausbildung im Isolationskörper 4 wiederum elektrisch isolierende Wände aus.

Unter dem zweiten Joint 22 bzw. unter der Jointwickelkammer 23b hindurch führt der erste Endabschnitt 11 des HTS-Bandleiters 10 in einer nutenartigen Vertiefung 24 hindurch (vgl. auch Fig. 1 hierzu).

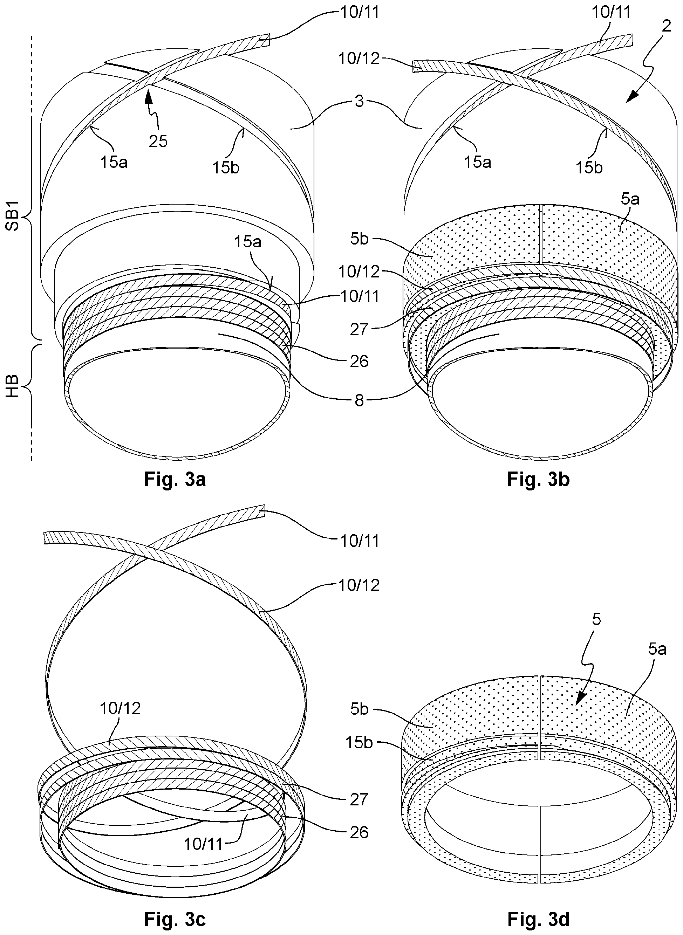

Die **Figuren 3a bis 3d** illustrieren die Ein- und Ausleitung der Endabschnitte 11, 12 des HTS-Bandleiters 10 in das Hauptwickelpaket 9 in der Hauptwickelkammer 8 näher. Der erste Endabschnitt 11 wird dabei in die radial innerste ("unterste") Lage 26 eingeleitet und der zweite Endabschnitt 12 aus der radial äußersten ("obersten") Lage 27 ausgeleitet (man beachte, dass jeweils nur einige Windungen der innersten Lage 26 und der äußersten Lage 27 dargestellt sind). Die beiden Endabschnitte 11, 12 sind im Spulenträger 2 in den nutenartigen Vertiefungen 15a, 15b geführt.

An axial von der Hauptwickelkammer 8 ausreichend entfernten Kreuzungsbereichen 25 kann der radial äußere Endabschnitt (hier der zweite Endabschnitt 12 in der nutenartigen Vertiefung 15b) einfach über die darunterliegende nutenartige Vertiefung 15a für den radial inneren Endabschnitt (hier der erste Endabschnitt 11) im Grundkörper 3 des Spulenträgers 2 geführt werden. Die Nutentiefen der beiden nutenartigen Vertiefungen 15a, 15b werden einfach unterschiedlich gewählt. Bevorzugt liegen die Endabschnitte 11, 12 im Kreuzungsbereich 25 aufeinander auf; aber selbst wenn nicht, ist die kleine Fläche des Kreuzungsbereichs 25 für den mechanischen Halt der Endabschnitte 11, 12 unproblematisch.

Liegt ein Kreuzungsbereich aber nahe an der Hauptwickelkammer 8, so dass der Kreuzungsbereich aufgrund der noch geringen Steigung (Ganghöhe) der nutenarteigen Vertiefungen 15a, 15 flächig ausgedehnt ist (und insbesondere sich über erhebliche Teile des Umfangs, z.B. mehr als 1/2 des Umfangs erstreckt), so könnten die Endabschnitte 11, 12 im Grundkörper 3 nicht mehr mechanisch stabil geführt werden; ein radiales Aufliegen wäre nicht möglich, da ausgehend von der Hauptwickelkammer 8 der (Helix-)Radius des HTS-Bandleiters 10 nur allmählich geändert werden kann, insbesondere um nicht Biegungen über die kurze Kante des HTS-Bandleiters einzubringen.

Deshalb ist am Grundkörper 3 ein Satz 5 von Trägerschalen 5a, 5b angeordnet, der eine Auflage für den radial äußeren Endabschnitt 12 des HTS-Bandleiters 10 zur Verfügung stellt; der Satz 5 ist auf den Grundkörper 3 des Spulenträgers 2 aufgesetzt, und typischerweise auch aufgeschraubt. Die nutenartige Vertiefung 15b für den radial äußeren Endabschnitt 12 verläuft ausgehend vom Grundkörper 3 im Satz 5 von Trägerschalten 5a, 5b weiter, bis zur radial äußeren Lage 27 des Hauptwickelpakets 8. Die nutenartige Vertiefung 15a für den radial inneren Endabschnitt 11 läuft ausgehend vom Grundkörper 3 unter dem Satz 5 von Trägerschalen 5a, 5b hindurch (siehe auch Fig. 1 hierzu).

In der gezeigten Ausführungsform besteht der Satz 5 von Trägerschalen 5a, 5b aus zwei Trägerschalen 5a, 5b ("Halbschalen"), die jeweils ca. 180° des Umfangs abdecken. Die Trägerschalen 5a, 5b sind aus elektrisch isolierendem Kunststoff gefertigt.

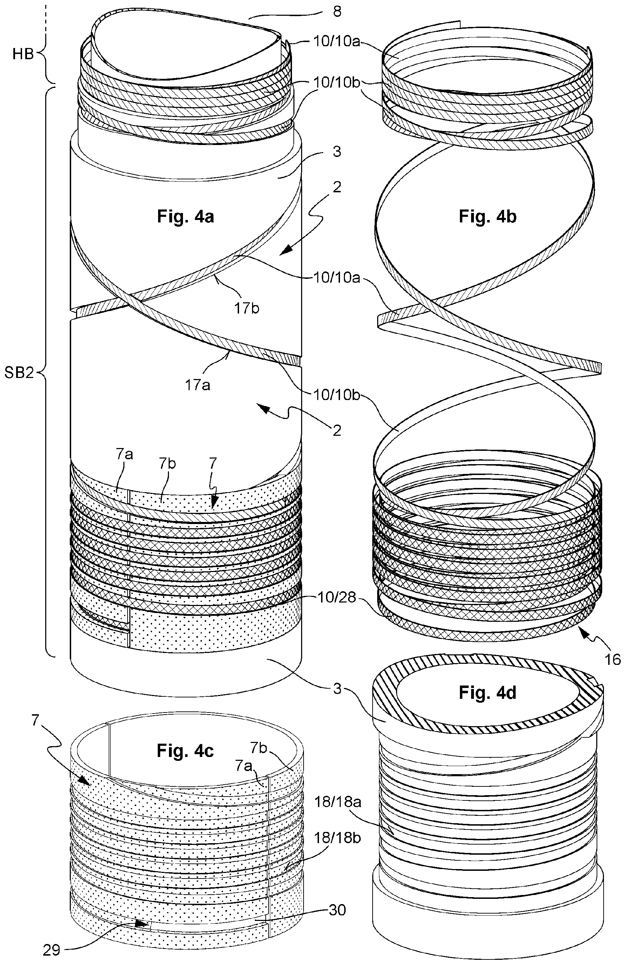

Die **Figuren 4a bis 4d** illustrieren die Ausbildung des Zwischenjoints 16 der Magnetspulensektion von Fig. 1 näher.

Falls eine Länge von HTS-Bandleiter 10 in der Magnetspulensektion verbaut werden soll, die größer ist als defektfreie HTS-Bandleiter-Stücke hergestellt werden können (etwa um besonders starke Magnetfelder zu erzeugen), können zwei HTS-Teilstücke 10a, 10b miteinander verbunden werden, die zusammen den HTS-Bandleiter 10 der Magnetspulensektion bilden. Typischerweise werden die HTS-Teilstücke 10a, 10b aus zwei mittleren Lagen des Hauptwickelpakets 8 ausgeleitet. Um komplexe Kreuzungen zu vermeiden, wird typischerweise nur ein Zwischenjoint 16 gesetzt (wie hier dargestellt); es ist aber grundsätzlich auch möglich, mehrere Zwischenjoints zu setzen.

Ausgehend von der Hauptwickelkammer 8, die nach unten hin durch einen Satz 6 von Flanschschalen 6a, 6b (nur in Fig. 1 dargestellt) zur mechanischen Führung begrenzt ist, führen eine Zuführungsnut 17b für das radial tiefer gelegene HTS-Teilband 10a und eine Zuführungsnut 17a für das radial höher gelegene HTS-Teilband 10b von der Hauptwickelkammer 8 im zweiten Seitenbereich SB2 zum Zwischenjoint 16. Dabei kreuzen sich die Zuführungsnuten 17a, 17b mehrfach. Die Zuführungsnuten 17a, 17b verlaufen helixförmig, wobei die Ganghöhe nach axial außen (hier nach unten) zunächst zunimmt und dann nahe dem Zwischenjoint 16 wieder abnimmt.

Der Zwischenjoint 16 ist hier durch unmittelbare flächige Verbindung der überlappenden HTS-Teilbänder 10a, 10b eingerichtet; der HTS-Bandleiter 10 verläuft in diesem Bereich als "Doppelband" 28 (alternativ könne auch ein SL-Brückenband vorgesehen sein, das mit den HTS-Teilbändern 10a, 10b überlappt, nicht dargestellt).

Das Doppelband 28 ist in zwei Lagen auf dem Spulenträger 2 aufgewickelt. Eine radial innere Lage des Doppelbands 28 ist unmittelbar auf dem Grundkörper 3 aufgewickelt; der Grundkörper 3 bildet dazu eine Zwischenjointnut 18 mit einem radial inneren Teil 18a aus, in welcher das Doppelband 28 geführt ist. Eine radial äußere Lage des Doppelbandes 28 ist auf einem Satz 7 von Trennschalen 7a, 7b ausgebildet, der auf dem Grundkörper 3 aufgesetzt ist. Der Satz 7 von Trennschalen 7a, 7b bildet die Zwischenjointnut 18 mit einem radial äußeren Teil 18b aus. Am axial äußeren Ende des Satzes 7 von Trennschalen 7a, 7b ist ein Bereich für einen Radiuswechsel 29 ausgebildet, in welchem die Zwischenjointnut 18 am inneren Teil 18a zu einem Durchführungsschlitz 30 hin im Radius zunimmt, und am äußeren Teil 18b zum Durchführungsschlitz 30 hin im Radius abnimmt. Das Doppelband 28 wird also in axialer Richtung über die beiden Lagen einmal hin und zurück geführt. Dadurch kann eine für einen guten elektrischen Kontakt ausreichende Überlappungslänge problemlos bereitgestellt werden.

In der gezeigten Ausführungsform besteht der Satz 7 von Trennschalen 7a, 7b aus zwei Trennschalen 7a, 7b ("Halbschalen"), die jeweils ca. 180° des Umfangs abdecken. Die Trennschalen 7a, 7b sind aus elektrisch isolierendem Kunststoff gefertigt.

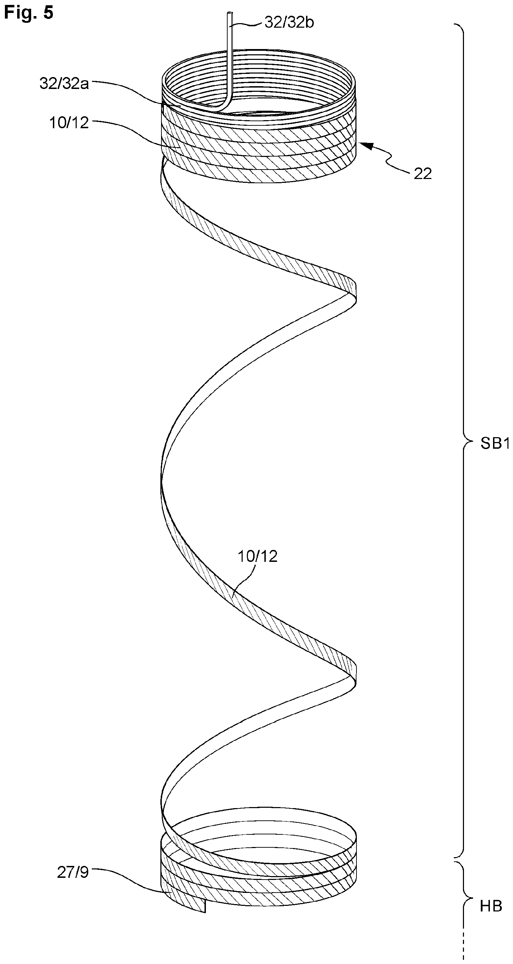

Die **Figur 5** illustriert den Verlauf eines Endabschnitts (hier dargestellt am Beispiel des zweiten Endabschnitts 12) des HTS-Bandleiters 10 vom Hauptwickelpaket 9 bis zum Joint (hier dem zweiten Joint 22).

In der gezeigten Ausführungsform ist der Endabschnitt 12 mit seinem zum zweiten Joint 22 gehörenden Teil mit unmittelbar axial aneinander grenzenden Windungen gewickelt flach auf dem Spulenträger (nicht dargestellt) helixartig gewickelt; die dortige Ganghöhe ist minimal und im Wesentlichen durch die Breite des HTS-Bandleiters 10 und den Wickelradius vorgegeben. Nach axial innen (unten) auf das Hauptwickelpaket 9 zu nimmt dann die Ganghöhe zunächst zu, um mit möglichst wenig Bandlänge in diesem Übergang auszukommen. Man beachte, dass HTS-Bandleiter 10 außerhalb des Hauptwickelpaketes 9 die Homogenität des erzeugten Magnetfelds im Probenvolumen beeinträchtigen kann. Sodann nimmt die Ganghöhe der helixartigen Wicklung wider ab, bis sie schließlich im Bereich des Hauptwickelpakets wider minimal ist, im Wesentlichen bestimmt durch die Leiterbreite und den Wickelradius, da im Hauptwickelpaket 9 die Windungen wieder flach und axial unmittelbar aneinander anliegen.

Allgemein gilt, dass der Verlauf eines HTS-Bandleiters 10 (etwa seines Endabschnitts 11, 12) durch eine zugehörige Führung im Spulenträger 2 bestimmt wird (etwa durch eine nutenartige Vertiefung 15a, 15b). Durch geeigneten Verlauf der Führung, und insbesondere geeignete Orientierung eines Nutgrunds 33 (nicht eingezeichnet in Fig. 5, siehe aber Fig. 1) kann zum einen die mechanische Belastung, insbesondere eine Biegung über die kurze Seite des HTS-Bandleiters 10, minimiert werden, und zum anderen kann die Orientierung des HTS-Bandleiters 10 in Hinblick auf das lokale Magnetfeld optimiert werden. Die lokale Flächennormale FN des Nutgrunds 33 kann dabei mit einem Winkel $\alpha$ zur Achse A des Spulenträgers 2 ausgerichtet werden, der von 90° abweicht. Normalkomponenten des Magnetfelds, die parallel zur lokalen Flächennormalen FN verlaufen, beeinträchtigen die Stromtragfähigkeit des HTS-Bandleiters 10 erheblich. Der lokale Nutgrund 33 sollte daher so ausgerichtet werden, dass die lokale Normalkomponente des Magnetfelds betragsmäßig nirgends größer ist als eine Referenz-Normalkomponente, die als Maximalwert einer lokalen Normalkomponente ohnehin am axial Rand des Hauptwickelpakets 9 im HTS-Bandleiter 10 erreicht wird.

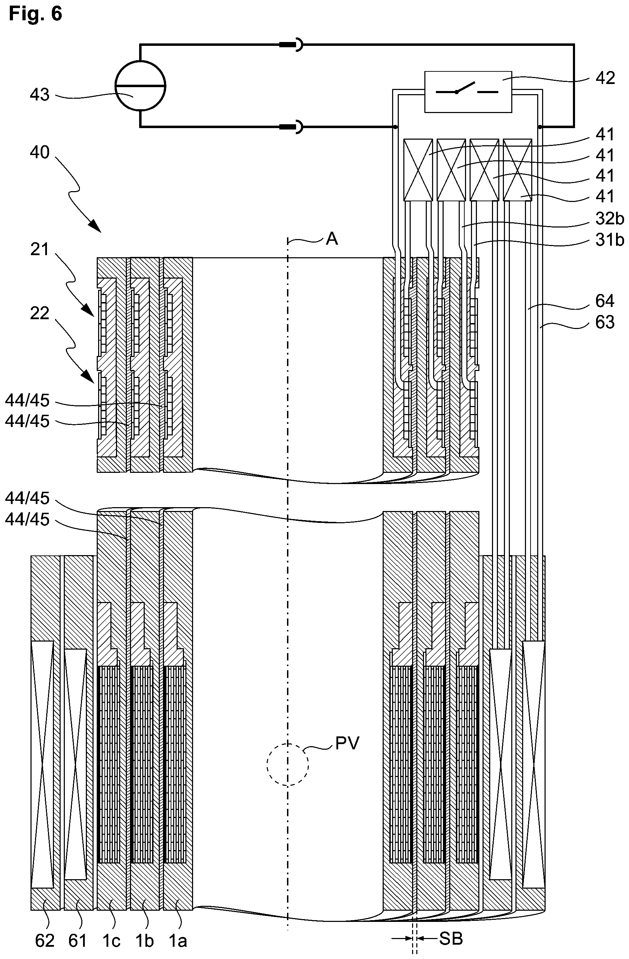

Die **Fig. 6** zeigt eine Ausführungsform einer erfindungsgemäßen Magnetanordnung 40.

Diese umfasst hier drei ineinander geschachtelte, erfindungsgemäße Magnetspulensektionen 1a, 1b, 1c mit HTS-Bandleiter und integrierten Joints 21, 22 (wie beispielsweise in den Figuren 1-5 gezeigt) sowie hier zwei weitere ineinander geschachtelte Magnetspulensektionen 61, 62, die jeweils einen solenoidförmig gewickelten LTS-Draht enthalten. Die Magnetspulensektionen 1a-1c sind dabei innerhalb der weiteren Magnetspulensektionen 61, 62 angeordnet. Die Magnetanordnung 40 insgesamt, also die Magnetspulensektionen 1a, 1b, 1c, und die weiteren Magnetspulensektionen 61, 62 zusammen, erzeugt im Probenvolumen PV ein homogenes Magnetfeld.

Die Magnetspulensektionen 1a-1c sind hier in axialer Richtung (vgl. Achse A) gleich lang und fluchten. Die Magnetspulensektionen 1a-1c und die weiteren Magnetspulensektionen 61, 62 sind hier über die Verbindungsabschnitte 31a, 32a der SL-Folgeleiter und weitere Verbindungsabschnitte 63, 64 miteinander elektrisch in Reihe geschaltet, wobei äußere Joints 41 eingesetzt werden. In der gezeigten Ausführungsform kann die Magnetanordnung 40 über den supraleitenden Schalter 42 supraleitend kurzgeschlossen werden, und damit in einen Dauerstrommodus ("persistent mode") geschaltet werden, in denen keine externe Stromzufuhr nötig ist und das Magnetfeld im Probenvolumen PV dauerhaft und praktisch ohne Drift gehalten werden kann. Eine elektrische Stromquelle 43 ist hier parallel zum Schalter 42 angeordnet, über den die Magnetanordnung 40 geladen und entladen werden kann.

Der zwischen benachbarten Magnetspulensektionen 1a, 1b oder 1b, 1c verbleibende Spalt 45 ist hier mit einem elektrisch isolierenden Füllmaterial 44, hier Gussmaterial im heißen Zustand, verfüllt worden, wobei das Gussmaterial im kalten Zustand aushärtet und im Betrieb die Magnetspulensektionen 1a-1c gegeneinander mechanisch stabilisiert. Die radiale Spaltbreite SB zwischen benachbarten Magnetspulensektionen 1a, 1b oder 1b, 1c beträgt typischerweise über den gesamten Umfang und die gesamte axiale Länge maximal 0,6 mm (also GSP$\leq$0,60mm), und im Mittel typischerweise maximal 0,5 mm (also MS$\leq$0,50mm).

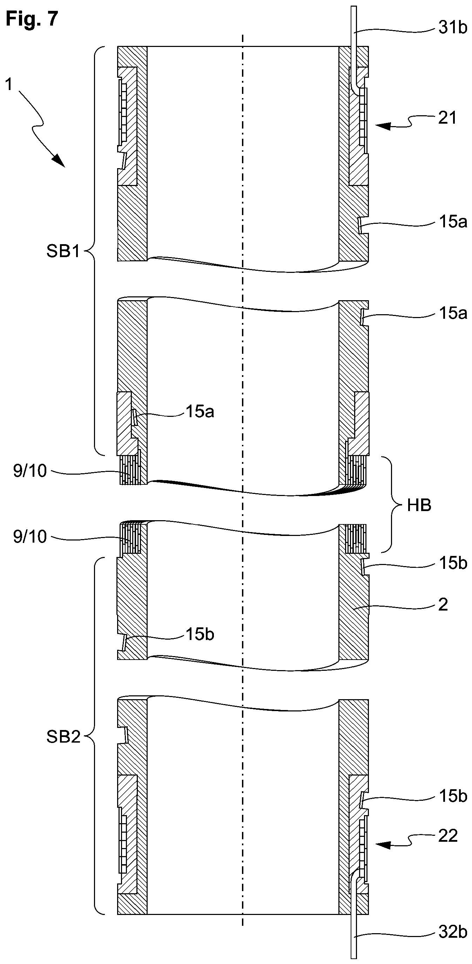

Man beachte, dass die Magnetspulensektionen 1a-1c, die weiteren Magnetspulensektionen 61, 62, die Verbindungsabschnitte 31b, 32b, die weiteren Verbindungsabschnitte 63, 64, die externen Joints 41 und der supraleitende Schalter 42 typischerweise innerhalb eines Kryostaten angeordnet sind, innerhalb dessen eine kryogene Temperatur eingerichtet werden kann (nicht näher dargestellt). Die **Fig. 7** zeigt eine weitere Ausführungsform einer erfindungsgemäßen Magnetspulensektion 1, ähnlich der in den Figuren 1 bis 5 vorgestellten Magnetspulensektion. Es werden nur die wesentlichen Unterschiede erläutert. Bei dieser Ausführungsform ist der erste Joint 21 im ersten Seitenbereich SB1 angeordnet, und der zweite Joint 22 im zweiten Seitenbereich SB2 gegenüber angeordnet. Die beiden nutenartigen Vertiefungen 15a, 15b, die den HTS-Bandleiter 10 vom Hauptwickelpaket 9 zu den Joints 21, 22 führen, benötigen in diesem Falle keine Kreuzungen. Die Verbindungsabschnitte 31b, 32b der SL-Folgeleiter sind hier an gegenüberliegenden Seiten axial aus dem Spulenträger 2 herausgeführt.

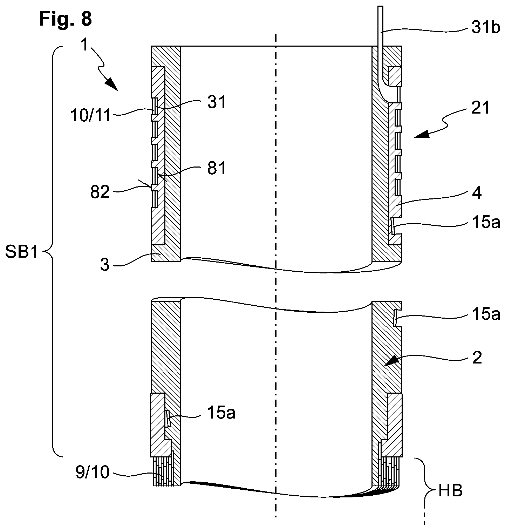

Die **Fig. 8** zeigt eine weitere Ausführungsform einer erfindungsgemäßen Magnetspulensektion 1, ähnlich der Magnetspulensektion von Fig. 7, wobei der Ausschnitt von Fig. 7 zur Vereinfachung auf den ersten Seitenbereich SB1 beschränkt ist. Es werden nur die wesentlichen Unterschiede zu Fig. 7 erläutert. Im ersten Seitenbereich 1 ist der erste Joint 21 ausgebildet (der zweite Joint ist hier im zweiten Seitenbereich ausgebildet, nicht dargestellt; man beachte aber, dass der gezeigte Aufbau des ersten Joints 21 analog auch angewandt werden kann, wenn der zweite Joint ebenfalls im ersten Seitenbereich ausgebildet ist). Der erste Joint 21 weist im Spulenträger 2, hier in einem Isolationskörper 4 aus elektrisch isolierendem Material (etwa Kunststoff), der auf dem Grundkörper 3 des Spulenträgers 2 aufsitzt, eine helixartig umlaufende Jointnut 81 auf, die hier insgesamt fünf Windungen aufweist. Zwischen den Windungen verbleibt jeweils ein die Windungen trennender Steg 82 des Spulenträgers 2. Aufgrund des isolierenden Materials des Isolationskörpers 4 sind die Wände der Jointnut 81 elektrisch isolierend.

In der Jointnut 81 ist hier radial innen der erste SL-Folgeleiter 31 aufgewickelt, wobei dieser jedoch auf die Breite des HTS-Bandleiters 10 breit gewalzt ist. In der Jointnut 81 radial außen ist der erste Endabschnitt 11 des HTS-Bandleiters 10 aufgewickelt.

Der gewalzte SL-Folgedraht 31 und der HTS-Bandleiter 10 liegen also in der Jointnut 81 mit jeweils einer Windung aufeinander auf und sind flächig elektrisch (bevorzugt supraleitend) verbunden. Die Jointnut 81 kann den HTS-Bandleiter 10 und den gewalzten SL-Folgeleiter 31 in jeder Windung einzeln führen und mechanisch stabilisieren.

Der erste Joint 21 weist hier fünf Umläufe von HTS-Bandleiter 10 und SL-Folgeleiter 31 um den Spulenträger 2 auf. Im Bereich des Verbindungsabschnitts 31b des SL-Folgeleiters 31 ist der SL-Folgeleiter 31 hier nicht breit gewalzt, sondern weist einen rechteckigen Querschnitt auf. Die nutenartige Vertiefung 15a führt den HTS-Bandleiter 10 vom ersten Joint 21 weiter zum Hauptwickelpaket 9.

Bezuaszeichenliste

| | |
|---|---|
| 1, 1a-1c | Magnetspulensektion |
| 2 | Spulenträger |
| 3 | Grundkörper des Spulenträgers |
| 4 | Isolationskörper |
| 5 | Satz von Trägerschalen |
| 5a, 5b | Trägerschalen |
| 6 | Satz von Flanschschalen |
| 6a, 6b | Flanschschalen |
| 7 | Satz von Trennschalen |
| 7a, 7b | Trennschalen |
| 8 | Hauptwickelkammer |
| 9 | Hauptwickelpaket |

| | |
|---|---|
| 10 | HTS-Bandleiter |
| 11 | erster Endabschnitt des HTS-Bandleiters |
| 12 | zweiter Endabschnitt des HTS-Bandleiters |
| 13 | axial innerer Abschnitt |
| 14 | axial äußerer Abschnitt |
| 15a, 15b | nutenartige Vertiefung |
| 16 | Zwischenjoint |
| 17a, 17b | Zuführungsnut |
| 18 | Zwischenjointnut |
| 18a | radial innerer Teil der Zwischenjointnut |
| 18b | radial äußerer Teil der Zwischenjointnut |
| 19a | Ausleitungsnut des ersten SL-Folgeleiters |
| 19b | Ausleitungsnut des zweiten SL-Folgeleiters |
| 21 | erster Joint |
| 22 | zweiter Joint |
| 23a, 23b | Jointkammer |
| 24 | nutenartige Vertiefung |
| 25 | Kreuzungsbereich |
| 26 | radial innerste Lage |
| 27 | radial äußerste Lage |
| 28 | Doppelband |
| 29 | Bereich des Radiuswechsels |
| 30 | Durchführungsschlitz |
| 31 | erster SL-Folgeleiter |
| 31a | Endabschnitt des ersten SL-Folgeleiters |
| 31b | Verbindungsabschnitt des ersten SL-Folgeleiters |
| 32 | zweiter SL-Folgeleiter |
| 32a | Endabschnitt des zweiten SL-Folgeleiters |
| 32b | Verbindungsabschnitt des zweiten SL-Folgeleiters |
| 33 | Nutgrund |
| 40 | Magnetanordnung |
| 41 | äußerer Joint zwischen Magnetspulensektionen |
| 42 | supraleitender Schalter |
| 43 | Stromquelle |
| 44 | Füllmaterial |
| 45 | radialer Spalt |
| A | Achse (Zylinderachse) des Spulenträgers |
| FN | Flächennormale des Nutgrunds |
| HB | Hauptbereich |
| PV | Probenvolumen |
| SB | Spaltbreite |
| SB1 | erster Seitenbereich |
| SB2 | zweiter Seitenbereich |
| RiH | kleinster Innenradius des Spulenträgers im Hauptbereich |
| RaH | größter Außenradius des Hauptwickelpakets |
| RT | größter Radius der Trägerschalen |
| RBS | Radialbereich der Magnetspulensektion |

**Patentansprüche**

1.  Magnetspulensektion (1; 1a-1c),

    umfassend einen im Wesentlichen zylindermantelförmigen Spulenträger (2), einen Hochtemperatursupraleiter(=HTS)-Bandleiter (10) und einen ersten Supraleiter(=SL)-Folgeleiter (31) mit einem ersten Joint (21) zwischen dem HTS-Bandleiter (10) und dem ersten SL-Folgeleiter (31), wobei der Spulenträger (2) einen Hauptbereich (HB) aufweist, in welchem ein Hauptwickelpaket (9) des HTS-Bandleiters (10) solenoidförmig auf den Spulenträger (2) aufgewickelt ist,

<div align="center">14</div>

wobei der Spulenträger (2) weiterhin einen ersten Seitenbereich (SB1) aufweist, der sich axial an einer ersten Seite an den Hauptbereich (HB) anschließt, und in welchem ein erster Endabschnitt (11) des HTS-Bandleiters (10) auf den Spulenträger (2) aufgewickelt ist,

wobei zumindest in einem axial inneren Abschnitt (13) des ersten Seitenbereichs (SB1) der erste Endabschnitt (11) des HTS-Bandleiters (10) in einer nutenartigen Vertiefung (15a, 24) des Spulenträgers (2) geführt ist, und wobei das Hauptwickelpaket (9) des HTS-Bandleiters (10) einen größten Außenradius RaH aufweist und der Spulenträger (2) im Hauptbereich (HB) einen kleinsten Innenradius RiH aufweist,

**dadurch gekennzeichnet,**

**dass** die Magnetspulensektion (1; 1a-1c) weiterhin einen zweiten SL-Folgeleiter (32) mit einem zweiten Joint (22) zum HTS-Bandleiter (10) umfasst,

**dass** in dem ersten Seitenbereich (SB1) oder in einem zweiten Seitenbereich (SB2), der sich axial an einer zweiten Seite an den Hauptbereich (HB) anschließt und der ersten Seite gegenüber liegt, ein zweiter Endabschnitt (12) des HTS-Bandleiters (10) auf den Spulenträger (2) aufgewickelt ist,

**dass** zumindest in einem axial inneren Abschnitt (13) des ersten oder zweiten Seitenbereichs (SB1, SB2) der zweite Endabschnitt (12) des HTS-Bandleiters (10) in einer nutenartigen Vertiefung (15b) des Spulenträgers (2) geführt ist,

**dass** in einem axial äußeren Abschnitt (14) des ersten Seitenbereichs (SB1) zumindest ein Teil des auf dem Spulenträger (2) aufgewickelten ersten Endabschnitts (11) des HTS-Bandleiters (10) mit einem Endabschnitt (31a) des ersten SL-Folgeleiters (31) flächig zur Ausbildung des ersten Joints (21) verbunden ist, und zumindest ein Teil des auf dem Spulenträger (2) aufgewickelten zweiten Endabschnitts (12) des HTS-Bandleiters (10) mit einem Endabschnitt (32a) des zweiten SL-Folgeleiters (32) zur Ausbildung des zweiten Joints (22) flächig verbunden ist,

**dass** der Spulenträger (2) insgesamt, der HTS-Bandleiter (10) insgesamt sowie der erste SL-Folgeleiter (31) zumindest im Bereich des ersten Joints (21) und der zweite SL-Folgeleiter (32) zumindest im Bereich des zweiten Joints (22) innerhalb eines Radialbereichs RBS der Magnetspulensektion (1) verlaufen, mit $0{,}80*RiH \leq RBS \leq 1{,}2*RaH$, bevorzugt $0{,}9*RiH \leq RBS \leq 1{,}1*RaH$, besonders bevorzugt $RiH \leq RBS \leq RaH$, und **dass** weiterhin

- der erste Joint (21) und der zweite Joint (22) jeweils über den gesamten Umfang des Spulenträgers (2) reichen, und/oder
- der erste Joint (21) und der zweite Joint (22) sich jeweils über eine Überlappungslänge, bezogen auf den HTS-Bandleiter (10), von wenigstens 0,1 m, bevorzugt wenigstens 0,5 m, erstrecken.

2. Magnetspulensektion (1) nach Anspruch 1, **dadurch gekennzeichnet, dass** im Hauptbereich (HB) der Spulenträger (2) eine umlaufende ringförmige Vertiefung als Hauptwickelkammer (8) aufweist, in der das Hauptwickelpaket (9) des HTS-Bandleiters (10) in mehreren Lagen solenoidförmig aufgewickelt ist.

3. Magnetspulensektion (1; 1a-1c) nach einem der vorhergehenden Ansprüche, **dadurch gekennzeichnet,**

**dass** im axial äußeren Abschnitt (14) des ersten Seitenbereichs (SB1) der Spulenträger (2) eine umlaufende ringförmige Vertiefung als erste Jointwickelkammer (23a) aufweist, in der zumindest der Teil des ersten Endabschnitts (11) des HTS-Bandleiters (10) mit mehreren nebeneinander liegenden Windungen und der Endabschnitt (31a) des ersten SL-Folgeleiters (31) mit mehreren nebeneinander liegenden Windungen übereinander liegend aufgewickelt sind,

und/oder **dass** im axial äußeren Abschnitt (14) des ersten oder zweiten Seitenbereichs (SB2) der Spulenträger (2) eine umlaufende ringförmige Vertiefung als zweite Jointwickelkammer (23b) aufweist, in der zumindest der Teil des zweiten Endabschnitts (12) des HTS-Bandleiters (10) mit mehreren nebeneinander liegenden Windungen und der Endabschnitt (32a) des zweiten SL-Folgeleiters (32) mit mehreren nebeneinander liegenden Windungen übereinander liegend aufgewickelt sind.

4. Magnetspulensektion (1; 1a-1c) nach Anspruch 3, **dadurch gekennzeichnet, dass** der Spulenträger (2) im Bereich der Wände der ersten Jointwickelkammer (23a) und/oder der Wände der zweiten Jointwickelkammer (23b) aus einem elektrisch isolierenden Material, insbesondere einem Kunststoff, ausgebildet ist.

5. Magnetspulensektion (1; 1a-1c) nach einem der vorhergehenden Ansprüche, **dadurch gekennzeichnet,**

**dass** im axial äußeren Abschnitt (14) des ersten Seitenbereichs (SB1) der Spulenträger (2) eine erste Jointnut (81) aufweist, die wenigstens einmal, bevorzugt mehrfach, um den Spulenträger (2) führt, und in der zumindest der Teil des ersten Endabschnitts (11) des HTS-Bandleiters (10) und der Endabschnitt (31a) des ersten SL-Folgeleiters (31) übereinander liegend geführt sind,

und/oder dass im axial äußeren Abschnitt (14) des ersten oder zweiten Seitenbereichs (SB1, SB2) der Spulenträger (2) eine zweite Jointnut aufweist, die wenigstens einmal, bevorzugt mehrfach, um den Spulenträger (2) führt, in der zumindest der Teil des zweiten Endabschnitts (12) des HTS-Bandleiters (10) und der Endabschnitt (32a) des zweiten SL-Folgeleiters (32) übereinander liegend geführt sind.

6. Magnetspulensektion (1; 1a-1c) nach Anspruch 5, **dadurch gekennzeichnet, dass** der Spulenträger (2) im Bereich der Wände der ersten Jointnut (81) und/oder der Wände der zweiten Jointnut aus einem elektrisch isolierenden Material, insbesondere einem Kunststoff, ausgebildet ist.

7. Magnetspulensektion (1; 1a-1c) nach einem der vorhergehenden Ansprüche, **dadurch gekennzeichnet, dass** in dem ersten Seitenbereich (SB1) auch der zweite Endabschnitt (12) des HTS-Bandleiters (10) auf den Spulenträger (2) aufgewickelt ist,

insbesondere wobei im axial inneren Abschnitt (13) des ersten Seitenbereichs (SB1) die nutenartigen Vertiefungen (15a, 15b) des ersten Endabschnitts (11) und des zweiten Endabschnitts (12) sich mehrfach kreuzen.

8. Magnetspulensektion (1; 1a-1c) nach Anspruch 7, **dadurch gekennzeichnet, dass** der Spulenträger (2) in einem axial an die Hauptwickelkammer (8) anschließenden Übergangsbereich des axial inneren Abschnitts (13) des ersten Seitenbereichs (SB1) mit einem Satz (5) von Trägerschalen (5a, 5b) ausgebildet ist, die auf dem übrigen Spulenträger (2) aufliegen und zusammen den übrigen Spulenträger (2) ringförmig umgreifen,

und dass im Übergangsbereich eine der nutenartigen Vertiefungen (15a, 15b) für den ersten Endabschnitt (11) und den zweiten Endabschnitt (12) des HTS-Bandleiters (10) in dem Satz (5) von Trägerschalen (5a, 5b) ausgebildet ist, und die andere der nutenartigen Vertiefungen (15a, 15b) für den ersten Endabschnitt (11) und den zweiten Endabschnitt (12) des HTS-Bandleiters (10) radial unter dem Satz (5) von Trägerschalen (5a, 5b) im übrigen Spulenträger (2) ausgebildet ist, wobei in dem Übergangsbereich der erste und zweite Endabschnitt (11, 12) des HTS-Bandleiters (10) sich wenigstens einmal kreuzen.

9. Magnetspulensektion (1; 1a-1c) nach Anspruch 7 oder 8, **dadurch gekennzeichnet, dass** im axial inneren Abschnitt (13) des ersten Seitenbereichs (SB1) die nutenartigen Vertiefungen (15a, 15b) für den ersten Endabschnitt (11) und den zweiten Endabschnitt (12) des HTS-Bandleiters (10) in wenigstens einem Kreuzungsbereich (25) der nutenartigen Vertiefungen (15a, 15b) mit einer unterschiedlichen Nutentiefe ausgebildet sind.

10. Magnetspulensektion (1; 1a-1c) nach einem der Ansprüche 7 bis 9,
**dadurch gekennzeichnet, dass** im axial äußeren Abschnitt (14) des ersten Seitenbereichs (SB1) eine nutenartige Vertiefung (24) für denjenigen Endabschnitt (11, 12) des HTS-Bandleiters (10), welcher den axial weiter außen liegenden Joint (21, 22) aufweist, radial innerhalb des axial weiter innen liegenden Joints (21, 22) verläuft.

11. Magnetspulensektion (1; 1a-1c) nach einem der Ansprüche 7 bis 10,
**dadurch gekennzeichnet, dass** im axial äußeren Abschnitt (14) des ersten Seitenbereichs (SB1) eine Ausleitungsnut (19a, 19b) für denjenigen SL-Folgeleiter (31, 32), der Teil des axial weiter innen liegenden Joints (21, 22) ist, radial innerhalb des axial weiter außen liegenden Joints (21, 22) verläuft.

12. Magnetspulensektion (1; 1a-1c) nach einem der vorhergehenden Ansprüche, **dadurch gekennzeichnet, dass** der HTS-Bandleiter (10) wenigstens zwei HTS-Teilbänder (10a, 10b) aufweist, die seriell über wenigstens einen Zwischenjoint (16) leitend miteinander verbunden sind,

wobei die HTS-Teilbänder (10a, 10b) im Bereich des wenigstens einen Zwischenjoints (16) im ersten Seitenbereich (SB1) oder im zweiten Seitenbereich (SB2) auf dem Spulenträger (2) aufgewickelt sind,
insbesondere wobei im Bereich des wenigstens einen Zwischenjoints (16) die HTS-Teilbänder (10a, 10b) mit einem gemeinsamen Supraleiter(=SL)-Brückenband verbunden sind.

13. Magnetspulensektion (1; 1a-1c) nach Anspruch 12, **dadurch gekennzeichnet, dass** der Spulenträger (2) im ersten Seitenbereich (SB1) oder im zweiten Seitenbereich (SB2) zwei Zuführungsnuten (17a, 17b) für die HTS-Teilbänder (10a, 10b) ausbildet, die von der Hauptwickelkammer (9) zum Bereich des wenigstens einen Zwischenjoints (16) führen, und der Spulenträger (2) im Bereich des Zwischenjoints (16) eine Zwischenjointnut (18) für die HTS-Teilbänder (10a, 10b) ausbildet.

**14.** Magnetspulensektion (1; 1a-1c) nach Anspruch 13 **dadurch gekennzeichnet, dass** der Spulenträger (2) im Bereich des wenigstens einen Zwischenjoints (16) mit einem Satz (7) von Trennschalen (7a, 7b) ausgebildet ist, die auf dem übrigen Spulenträger (2) aufliegen und zusammen den übrigen Spulenträger (2) ringförmig umgreifen, und dass ein radial äußerer Teil (18b) der Zwischenjointnut (18) in dem Satz (7) von Trennschalen (7a, 7b) ausgebildet ist, und ein radial innerer Teil (18a) der Zwischenjointnut (18) radial unter dem Satz (7) von Trennschalen (7a, 7b) im übrigen Spulenträger (2) ausgebildet ist, insbesondere wobei der Satz (7) von Trennschalen (7a, 7b) einen Bereich (29) für den Radiuswechsel des Zwischenjoints (16) aufweist.

**15.** Magnetspulensektion (1; 1a-1c) nach einem der Ansprüche 12 bis 14,

**dadurch gekennzeichnet, dass** in dem ersten Seitenbereich (SB1) auch der zweite Endabschnitt (12) des HTS-Bandleiters (10) auf den Spulenträger (2) aufgewickelt ist, und die HTS-Teilbänder (10a, 10b) im Bereich des wenigstens einen Zwischenjoints (16) im zweiten Seitenbereich (SB2) auf dem Spulenträger (2) aufgewickelt sind,

insbesondere wobei der Spulenträger (2) mit seiner Zylinderachse (A) vertikal sowie dem zweiten Seitenbereich (SB2) unten und dem ersten Seitenbereich (SB1) oben ausgerichtet ist.

**16.** Magnetspulensektion (1) nach einem der vorhergehenden Ansprüche,

**dadurch gekennzeichnet, dass**

- die nutenartigen Vertiefungen (15a, 15b, 24), in denen der HTS-Bandleiter (10) zumindest im axial innen liegenden Abschnitt (13) des ersten und/oder zweiten Seitenbereichs (SB1, SB2) geführt sind,
- und gegebenenfalls Jointnuten, in denen die ersten und/oder zweiten Endabschnitte (11, 12) des HTS-Bandleiters (10) im axial äußeren Abschnitt (14) des ersten und/oder zweiten Seitenbereichs (SB1, SB2) geführt sind,
- und gegebenenfalls Zuführungsnuten (17a, 17b) und Zwischenjointnuten (18) für mit einem Zwischenjoint (16) verbundene HTS-Teilbänder (10a, 10b) des HTS-Bandleiters (10),

zumindest teilweise mit einem Nutgrund (33) ausgebildet sind, auf dem der HTS-Bandleiter (10) aufliegt und dessen lokale Flächennormale (FN) einen von 90° abweichenden Winkel (a) zur Achse (A) des Spulenträgers (2) aufweist.

**17.** Magnetspulensektion (1; 1a-1c) nach einem der vorhergehenden Ansprüche, **dadurch gekennzeichnet,**

**dass** der erste SL-Folgeleiter (31) und/oder der zweite SL-Folgeleiter (32) ein Tieftemperatursupraleiter(=LTS)-Material, insbesondere NbTi, enthalten,
und/oder dass der erste SL-Folgeleiter (31) und/oder der zweite SL-Folgeleiter (32) $MgB_2$ enthalten,
und/oder dass der HTS-Bandleiter (10) ReBCO, insbesondere YBCO, oder Bi2223 enthält.

**18.** Magnetspulensektion (1; 1a-1c) nach einem der vorhergehenden Ansprüche, **dadurch gekennzeichnet, dass** im ersten Seitenbereich (SB1) der HTS-Bandleiter (10) des ersten Endabschnitts (11) und im ersten oder zweiten Seitenbereichs (SB1, SB2) der HTS-Bandleiter (10) des zweiten Endabschnitts (12) jeweils helixförmig gewickelt sind, mit einer nach axial außen hin zunächst zunehmenden und dann wieder abnehmenden Ganghöhe.

**19.** Magnetspulensektion (1; 1a-1c) nach einem der vorhergehenden Ansprüche, **dadurch gekennzeichnet, dass** der erste SL-Folgeleiter (31) und der zweite SL-Folgeleiter (32) jeweils mit einem Verbindungsabschnitt (31b, 32b) vom axial äußeren Abschnitt (14) des ersten oder zweiten Seitenbereichs (SB1, SB2) axial weg führen.

**20.** Magnetanordnung (40), umfassend mehrere Magnetspulensektionen (1; 1a-1c) nach einem der vorhergehenden Ansprüche, wobei die Magnetspulensektionen (1; 1a-1c) ineinander geschachtelt angeordnet sind, insbesondere wobei für eine über den gesamten Umfang gemittelte Spaltbreite MS eines jeweiligen radialen Spalts (45) zwischen benachbarten Magnetspulensektionen (1; 1a-1c) gilt: MS ≤ 1 mm, bevorzugt MS ≤ 0,5 mm.

**21.** Magnetanordnung (40) nach Anspruch 20, **dadurch gekennzeichnet, dass** das Hauptwickelpaket (9) einer jeweiligen radial inneren Magnetspulensektion (1; 1a-1c) radial nach außen hin an einer Innenseite des Spulenträgers (2) der radial nächst äußeren Magnetspulensektion (1; 1a-1c) anliegt, oder dass ein jeweiliger radialer Spalt (45) zwischen benachbarten Magnetspulensektionen (1; 1a-1c) mit einem Füllmaterial (44) verfüllt ist, insbesondere wobei das Füllmaterial (44) elektrisch isolierend ist, und insbesondere wobei das Füllmaterial (44) ein ausgehärtetes Gussmaterial und/oder Folien umfasst.

22. Magnetanordnung (40) nach Anspruch 20 oder 21, **dadurch gekennzeichnet, dass** die Magnetspulensektionen (1; 1a-1c) mit einer identischen axialen Länge der Spulenträger (2) ausgebildet sind und die Spulenträger (2) axial fluchten.

23. Magnetanordnung (40) nach einem der Ansprüche 20 bis 22, **dadurch gekennzeichnet, dass** die Magnetspulensektionen (1; 1a-1c) über ihre ersten SL-Folgeleiter (31) und zweiten SL-Folgeleiter (32) leitend miteinander verbunden sind.

24. Magnetanordnung (40) nach einem der Ansprüche 20 bis 23, **dadurch gekennzeichnet, dass** die Magnetanordnung (40) dazu ausgebildet ist, in einem Probenvolumen (PV) von wenigstens 0,5 cm$^3$ im Inneren der innersten Magnetspulensektion (1; 1a) ein Magnetfeld einer Stärke B0 und einer Homogenität von 100 ppm oder besser zu erzeugen, und dass die ersten Joints (21) und zweiten Joints (22), und bevorzugt auch gegebenenfalls der oder die Zwischenjoints (16), der Magnetspulensektionen (1; 1a-1c) axial so weit vom Probenvolumen (PV) beabstandet angeordnet sind, dass für die größte Magnetfeldstärke Bjoint an jedem dieser Joints (21, 22, 16) betragsmäßig gilt:

$$Bjoint \leq 1/2*B0,$$

$$bevorzugt\ Bjoint \leq 1/10*B0,$$

$$besonders\ bevorzugt\ Bjoint \leq 1/50*B0,$$

$$insbesondere\ wobei\ B0 \geq 20\ T$$

ist

25. Magnetanordnung (40) nach einem der Ansprüche 20 bis 23, wobei wenigstens eine der Magnetspulensektionen (1; 1a-1c) nach Anspruch 16 ausgebildet ist,

   **dadurch gekennzeichnet,**
   **dass** die Magnetspulensektionen (1; 1a-1c) elektrisch in Serie geschaltet sind,
   und **dass** die lokale Flächennormale (FN) des Nutgrunds (33) so verläuft, dass

      - ein Biegen über die kurze Kante des auf dem Nutgrund (33) aufliegenden HTS-Bandleiters (10) so klein ist, dass eine Dehnung des HTS-Bandleiters auch an dessen Rändern nirgends 0,6% überschreitet, bevorzugt nirgends 0,2% überschreitet, besonders bevorzugt dass kein Biegen über die kurze Kante des auf dem Nutgrund (33) aufliegenden HTS-Bandleiters (10) erfolgt, und gleichzeitig
      - eine lokale Normalkomponente eines durch die Magnetanordnung (40) insgesamt erzeugten Magnetfelds, welche parallel zur lokalen Flächennormalen (FN) des Nutgrunds (33) liegt, betragsmäßig überall kleiner oder gleich ist einer Referenz-Normalkomponente des Magnetfelds, die am HTS-Bandleiter (10) in den axial äußersten Windungen des Hauptwickelpakets (9) senkrecht zur lokalen Bandebene des HTS-Bandleiters (10) maximal vorliegt.

**Claims**

1. A solenoidal magnet section (1; 1a-1c),

   comprising an essentially hollow-cylindrical coil former (2), a high-temperature-superconductor (HTS) tape (10) and a first follow-on superconductor (31) with a first joint (21) between the HTS tape (10) and the first follow-on superconductor (SL) (31),
   the coil former (2) having a main region (HB) in which a main winding package (9) of the HTS tape (10) is wound in a solenoidal manner onto the coil former (2),

the coil former (2) also having a first lateral region (SB1) which axially adjoins the main region (HB) on a first side and in which a first terminal section (11) of the HTS tape (10) is wound onto the coil former (2),

the first terminal section (11) of the HTS tape (10) being guided in a groove (15a, 24) in the coil former (2) at least in an axially inner section (13) of the first lateral region (SB1),

and the main winding package (9) of the HTS tape (10) having a largest outer radius RaH, and the coil former (2) having a smallest inner radius RiH in the main region (HB),

**characterized in that**

the solenoidal magnet section (1; 1a-1c) further comprises a second follow-on superconductor (32) with a second joint (22) to the HTS tape (10), **in that** in the first lateral region (SB1) or in a second lateral region (SB2) which axially adjoins the main region (HB) on a second side and lies opposite to the first side, a second terminal section (12) of the HTS tape (10) is wound onto the coil former (2),

**in that** at least in an axially inner section (13) of the first or the second lateral region (SB1, SB2), the second terminal section (12) of the HTS tape (10) is guided in a groove (15b) in the coil former (2),

**in that** in an axially outer section (14) of the first lateral region (SB1) at least a part of the first terminal section (11) of the HTS tape (10) wound onto the coil former (2) is connected in a laminar manner to a terminal section (31a) of the first follow-on superconductor (31) to form the first joint (21) and at least a part of the second terminal section (12) of the HTS tape (10) wound onto the coil former (2) is connected in a laminar manner to a terminal section (32a) of the second follow-on superconductor (32) to form the second joint (22),

**in that** the coil former (2) as a whole, the HTS tape (10) as a whole, and the first follow-on superconductor (31) at least in the region of the first joint (21), and the second follow-on superconductor (32) at least in the region of the second joint (22), run within a radial range RBS of the solenoidal magnet section (1), where $0.80*RiH \leq RBS \leq 1.2*RaH$, preferably $0.9*RiH \leq RBS \leq 1.1*RaH$, particularly preferably $RiH \leq RBS \leq RaH$, and that moreover

- the first joint (21) and the second joint (22) each extend over the entire circumference of the coil former (2), and/or
- the first joint (21) and the second joint (22) each extend over an overlap length, relative to the HTS tape (10), of at least 0.1 m, preferably at least 0.5 m.

**2.** The solenoidal magnet section (1) according to claim 1, **characterized in that** in the main region (HB) the coil former (2) has a circumferential annular recess as a main winding chamber (8), in which the main winding package (9) of the HTS tape (10) is wound in several layers into a solenoid.

**3.** The solenoidal magnet section (1; 1a-1c) according to any of the preceding claims, **characterized in that**

in the axially outer section (14) of the first lateral region (SB1), the coil former (2) has a circumferential annular recess as a first joint winding chamber (23a) in which at least the part of the first terminal section (11) of the HTS tape (10) with a plurality of adjacent turns and the terminal section (31a) of the first follow-on superconductor (31) with a plurality of adjacent turns are wound so as to lie one above the other,

and/or **in that** in the axially outer section (14) of the first or the second lateral region (SB2), the coil former (2) has a circumferential annular recess as a second joint winding chamber (23b) in which at least the part of the second terminal section (12) of the HTS tape (10) with a plurality of adjacent turns and the terminal section (32a) of the second follow-on superconductor (32) with a plurality of adjacent turns are wound so as to lie one above the other.

**4.** The solenoidal magnet section (1; 1a-1c) according to claim 3, **characterized in that** the coil former (2) is made of an electrically insulating material, in particular a plastics material, in the region of the walls of the first joint winding chamber (23a) and/or of the walls of the second joint winding chamber (23b).

**5.** The solenoidal magnet section (1; 1a-1c) according to any of the preceding claims, **characterized in that**

the coil former (2) has a first joint groove (81) in the axially outer section (14) of the first lateral region (SB1), which groove passes at least once, preferably multiple times, around the coil former (2) and in which at least the part of the first terminal section (11) of the HTS tape (10) and the terminal section (31a) of the first follow-on superconductor (31) are guided so as to lie one above the other,

and/or that in the axially outer section (14) of the first or the second lateral region (SB1, SB2), the coil former (2) has a second joint groove which passes at least once, preferably several times, around the coil former (2), in which groove at least the part of the second terminal section (12) of the HTS tape (10) and the terminal section (32a) of the second follow-on superconductor (32) are guided so as to lie one above the other.

6.  The solenoidal magnet section (1; 1a-1c) according to claim 5, **characterized in that** the coil former (2) is made of an electrically insulating material, in particular a plastics material, in the region of the walls of the first joint groove (81) and/or of the walls of the second joint groove.

7.  Solenoidal magnet section (1; 1a-1c) according to any of the preceding claims, **characterized in that** the second terminal section (12) of the HTS tape (10) is also wound onto the coil former (2) in the first lateral region (SB1), in particular the grooves (15a, 15b) of the first terminal section (11) and of the second terminal section (12) intersecting multiple times in the axially inner section (13) of the first lateral region (SB1).

8.  The solenoidal magnet section (1; 1a-1c) according to claim 7, **characterized in that** in a transition region of the axially inner section (13) of the first lateral region (SB1) axially adjoining the main winding chamber (8), the coil former (2) is formed with a set (5) of support shells (5a, 5b) which sit on the rest of the coil former (2) and together annularly surround the rest of the coil former (2),
    and **in that** in the transition region one of the grooves (15a, 15b) is formed in the set (5) of support shells (5a, 5b) for the first terminal section (11) and the second terminal section (12) of the HTS tape (10), and the other of the grooves (15a, 15b) is formed in the rest of the coil former (2) radially below the set (5) of support shells (5a, 5b) for the first terminal section (11) and the second terminal section (12) of the HTS tape (10), the first and the second terminal section (11, 12) of the HTS tape (10) intersecting at least once in the transition region.

9.  The solenoidal magnet section (1; 1a-1c) according to either claim 7 or claim 8, **characterized in that** in the axially inner section (13) of the first lateral region (SB1), the grooves (15a, 15b) for the first terminal section (11) and the second terminal section (12) of the HTS tape (10) are formed with a different groove depth in at least one intersection region (25) of the grooves (15a, 15b).

10. The solenoidal magnet section (1; 1a-1c) according to any of claims 7 to 9, **characterized in that** in the axially outer section (14) of the first lateral region (SB1), a groove (24) for the terminal section (11, 12) of the HTS tape (10) which comprises the joint (21, 22) lying axially further outside runs radially inside the joint (21, 22) lying axially further inside.

11. The solenoidal magnet section (1; 1a-1c) according to any of claims 7 to 10, **characterized in that** in the axially outer section (14) of the first lateral region (SB1), an exit groove (19a, 19b) for the follow-on superconductor (31, 32) which is part of the joint (21, 22) lying axially further inside runs radially inside the joint (21, 22) lying axially further outside.

12. The solenoidal magnet section (1; 1a-1c) according to any of the preceding claims, **characterized in that** the HTS tape (10) has at least two HTS tape segments (10a, 10b) which are serially connected to one another conductively via at least one intermediate joint (16),

    the HTS tape segments (10a, 10b) being wound onto the coil former (2) in the region of the at least one intermediate joint (16) in the first lateral region (SB1) or in the second lateral region (SB2),
    the HTS tape segments (10a, 10b) in particular being connected to a common superconducting (SL) bridge tape in the region of the at least one intermediate joint (16).

13. The solenoidal magnet section (1; 1a-1c) according to claim 12, **characterized in that** the coil former (2) forms two connection grooves (17a, 17b) for the HTS tape segments (10a, 10b) in the first lateral region (SB1) or in the second lateral region (SB2), which connection grooves lead from the main winding chamber (8) to the region of the at least one intermediate joint (16), and the coil former (2) forms an intermediate joint groove (18) for the HTS tape segments (10a, 10b) in the region of the intermediate joint (16).

14. The solenoidal magnet section (1; 1a-1c) according to claim 13, **characterized in that** in the region of the at least one intermediate joint (16) the coil former (2) is formed with a set (7) of separation shells (7a, 7b) which sit on the rest of the coil former (2) and together annularly surround the rest of the coil former (2),

    and **in that** a radially outer part (18b) of the intermediate joint groove (18) is formed in the set (7) of separation shells (7a, 7b), and a radially inner part (18a) of the intermediate joint groove (18) is formed radially below the set (7) of separation shells (7a, 7b) in the rest of the coil former (2),
the set (7) of separation shells (7a, 7b) in particular having a region (29) for the radial transition of the intermediate joint (16).

15. The solenoidal magnet section (1; 1a-1c) according to any of claims 12 to 14, **characterized in that** the second terminal section (12) of the HTS tape (10) is also wound onto the coil former (2) in the first lateral region (SB1), and the HTS tape segments (10a, 10b) in the region of the at least one intermediate joint (16) are wound onto the coil former (2) in the second lateral region (SB2),
in particular wherein the coil former (2) is arranged with its cylindrical axis (A) being vertical and with the second lateral region (SB2) at the bottom and the first lateral region (SB1) at the top.

16. The solenoidal magnet section (1) according to any of the preceding claims, **characterized in that**

- the grooves (15a, 15b, 24) in which the HTS tape (10) is guided at least in the axially inner section (13) of the first and/or the second lateral region (SB1, SB2),
- and optionally joint grooves in which the first and/or the second terminal section (11, 12) of the HTS tape (10) are guided in the axially outer section (14) of the first and/or the second lateral region (SB1, SB2),
- and optionally connection grooves (17a, 17b) and intermediate joint grooves (18) for HTS tape segments (10a, 10b) of the HTS tape (10) which are connected to an intermediate joint (16)

are formed at least in part with a groove bottom (33) on which the HTS tape (10) rests and the local surface normal (FN) of which is at an angle ($\alpha$) other than 90° relative to the axis (A) of the coil former (2).

17. The solenoidal magnet section (1; 1a-1c) according to any of the preceding claims, **characterized in that**

the first follow-on superconductor (31) and/or the second follow-on superconductor (32) contain a low-temperature-superconductor material (LTS material), in particular NbTi,
and/or **in that** the first follow-on superconductor (31) and/or the second follow-on superconductor (32) contain $MgB_2$,
and/or **in that** the HTS tape (10) contains ReBCO, in particular YBCO, or Bi2223.

18. Solenoidal magnet section (1; 1a-1c) according to any of the preceding claims, **characterized in that** in the first lateral region (SB1) the HTS tape (10) of the first terminal section (11) and in the first or the second lateral region (SB1, SB2) the HTS tape (10) of the second terminal section (12) are each helically wound, with a pitch length that initially increases axially outward and then decreases again.

19. The solenoidal magnet section (1; 1a-1c) according to any of the preceding claims, **characterized in that** a respective connecting section (31b, 32b) of the first follow-on superconductor (31) and of the second follow-on superconductor (32) leads in each case axially away from the axially outer section (14) of the first or the second lateral region (SB1, SB2).

20. A magnet arrangement (40) comprising a plurality of solenoidal magnet sections (1; 1a-1c) according to any of the preceding claims, the solenoidal magnet sections (1; 1a-1c) being arranged so as to be inserted into one another, the following applying in particular to a gap width MS of a respective radial gap (45) between adjacent solenoidal magnet sections (1; 1a-1c),averaged over the entire circumference: MS ≤ 1 mm, preferably MS ≤ 0.5 mm.

21. The magnet arrangement (40) according to claim 20, **characterized in that** the main winding package (9) of a respective radially inner solenoidal magnet section (1; 1a-1c) rests radially outward against an inside of the coil former (2) of the radially next outer solenoidal magnet section (1; 1a-1c),
or **in that** a respective radial gap (45) between adjacent solenoidal magnet sections (1; 1a-1c) is filled with a filling material (44), the filling material (44) in particular being electrically insulating, and the filling material (44) in particular comprising a cured casting material and/or films.

22. The magnet arrangement (40) according to either claim 20 or claim 21, **characterized in that** the solenoidal magnet sections (1; 1a-1c) are formed with an identical axial length of the coil formers (2) and the coil formers (2) are axially aligned.

23. The magnet arrangement (40) according to any of claims 20 to 22, **characterized in that** the solenoidal magnet sections (1; 1a-1c) are conductively connected to one another via their first follow-on superconductors (31) and second follow-on superconductors (32).

24. The magnet arrangement (40) according to any of claims 20 to 23, **characterized in that** the magnet arrangement (40) is designed to generate a magnetic field with a strength B0 and a homogeneity of 100 ppm or better in a sample volume (PV) of at least 0.5 cm$^3$ inside the innermost solenoidal magnet section (1; 1a), and **in that** the first joints (21) and the second joints (22), and also preferably optionally the intermediate joint or joints (16), of the solenoidal magnet sections (1; 1a-1c) are axially distanced far enough from the sample volume (PV) that the following applies for the magnitude of the strongest magnetic field Bjoint at each of these joints (21, 22, 16):

$$Bjoint \leq 1/2*B0,$$

$$preferably\ Bjoint \leq 1/10*B0,$$

$$particularly\ preferably\ Bjoint \leq 1/50*B0,$$

$$in\ particular\ B0 \geq 20\ T.$$

25. The magnet arrangement (40) according to any of claims 20 to 23, at least one of the solenoidal magnet sections (1; 1a-1c) being designed according to claim 16,

**characterized in that**
the solenoidal magnet sections (1; 1a-1c) are electrically connected in series,
and **in that** the local surface normal (FN) of the groove bottom (33) runs in such a way that

- bending about the short edge of the HTS tape (10) lying on the groove bottom (33) is so small that elongation of the HTS tape never exceeds 0.6% even at its edges, preferably never exceeds 0.2%, particularly preferably **in that** no bending about the short edge of the HTS tape (10) lying on the groove bottom (33) takes place, and at the same time
- a local normal component of a magnetic field generated overall by the magnet arrangement (40), which component is parallel to the local surface normal (FN) of the groove bottom (33), everywhere is in magnitude smaller than or equal to a reference normal component of the magnetic field,

which reference normal component is the maximum of all components normal to the local tape surface of the HTS tape (10) at the axially outermost turns of the main winding package (9).

**Revendications**

1. Section de bobine électromagnétique (1 ; 1a-1c) :

comprenant un support de bobine (2) pour l'essentiel en forme d'enveloppe cylindrique, un conducteur en ruban supraconducteur à haute température (=HTS) (10) et un premier conducteur de suite supraconducteur (=SL) (31) avec un premier joint (21) entre le conducteur en ruban HTS (10) et le premier conducteur de suite SL (31), le support de bobine (2) comportant une région principale (HB) dans laquelle un paquet d'enroulement principal (9) du conducteur en ruban HTS (10) est enroulé en forme de solénoïde sur le support de bobine (2) ;
le support de bobine (2) comportant en outre une première région latérale (SB1) raccordée dans le plan axial, au niveau d'un premier côté, à la région principale (HB) dans laquelle la première section d'extrémité (11) du conducteur en ruban HTS (10) est enroulée sur le support de bobine (2) ;
la première section d'extrémité (11) du conducteur en ruban HTS (10) étant guidée dans un renfoncement de type rainure (15a, 24) du support de bobine (2) au moins dans une section intérieure dans le plan axial (13) de la première région latérale (SB1) et le paquet d'enroulement principal (9) du conducteur en ruban HTS (10) comportant un plus grand rayon extérieur RaH et le support de bobine (2) comportant dans la région principale (HB) un plus petit rayon intérieur RiH ;

**caractérisée en ce que** :

la section de bobine électromagnétique (1; 1a-1c) comprend en outre un deuxième conducteur de suite SL (32) avec un deuxième joint (22) reliant au conducteur en ruban HTS (10) ;

qu'une deuxième section d'extrémité (12) du conducteur en ruban HTS (10) est enroulée sur le support de bobine (2) dans la première région latérale (SB1) ou dans une deuxième région latérale (SB2) raccordée dans le plan axial, au niveau d'un deuxième côté, à la région principale (HB) et opposée au premier côté ;

que la deuxième section d'extrémité (12) du conducteur en ruban HTS (10) est guidée dans un renfoncement de type rainure (15b) du support de bobine (2) au moins dans une section intérieure dans le plan axial (13) de la première ou deuxième région latérale (SB1, SB2) ;

qu'au moins une partie de la première section d'extrémité (11) du conducteur en ruban HTS (10) enroulée sur le support de bobine (2) est reliée à plat à une section d'extrémité (31a) du premier conducteur de suite SL (31) pour former le premier joint (21) dans une section extérieure dans le plan axial (14) de la première région latérale (SB1) et qu'au moins une partie de la deuxième section d'extrémité (12) du conducteur en ruban HTS (10) enroulée sur le support de bobine (2) est reliée à plat à une section d'extrémité (32a) du deuxième conducteur de suite SL (32) pour la formation du deuxième joint (22) ;

que la globalité du support de bobine (2), la globalité du conducteur en ruban HTS (10) ainsi que le premier conducteur de suite SL (31) s'étendent au moins dans la région du premier joint (21) et que le deuxième conducteur de suite SL (32) s'étend au moins dans la région du deuxième joint (22) à l'intérieur d'une région radiale RBS de la section de bobine électromagnétique (1), avec :

$0{,}80*RiH \leq RBS \leq 1{,}2*RaH$, de façon préférée $0{,}9*RiH \leq RBS \leq 1{,}1*RaH$, de façon particulièrement préférée $RiH \leq RBS \leq RaH$ ;

et qu'en outre :

- le premier joint (21) et le deuxième joint (22) atteignent respectivement la totalité du périmètre du support de bobine (2) ; et/ou
- le premier joint (21) et le deuxième joint (22) s'étendent respectivement sur une longueur de recouvrement, par rapport au conducteur en ruban HTS (10), d'au moins 0,1 m, de façon préférée d'au moins 0,5 m.

2. Section de bobine électromagnétique (1) selon la revendication 1, **caractérisée en ce que** dans la région principale (HB), le support de bobine (2) comporte un renfoncement périphérique de forme annulaire prenant la forme d'un compartiment d'enroulement principal (8) dans lequel le paquet d'enroulement principal (9) du conducteur en ruban HTS (10) est enroulé dans plusieurs couches en forme de solénoïde.

3. Section de bobine électromagnétique (1; 1a-1c) selon l'une quelconque des revendications précédentes, **caractérisée en ce que** :

dans la section extérieure dans le plan axial (14) de la première région latérale (SB1), le support de bobine (2) comporte un renfoncement périphérique de forme annulaire prenant la forme d'un premier compartiment d'enroulement de joint (23a) dans lequel au moins la partie de la première section d'extrémité (11) du conducteur en ruban HTS (10) avec plusieurs circonvolutions placées côte à côte et la section d'extrémité (31a) du premier conducteur de suite SL (31) avec plusieurs circonvolutions placées côte à côte sont enroulées l'une au-dessus de l'autre ; et/ou

que dans la section extérieure dans le plan axial (14) de la première ou deuxième région latérale (SB2), le support de bobine (2) comporte un renfoncement périphérique de forme annulaire prenant la forme du deuxième compartiment d'enroulement de joint (23b) dans lequel au moins la partie de la deuxième section d'extrémité (12) du conducteur en ruban HTS (10) avec plusieurs circonvolutions placées côte à côte et la section d'extrémité (32a) du deuxième conducteur de suite SL (32) avec plusieurs circonvolutions placées côte à côte sont enroulées les unes sur les autres.

4. Section de bobine électromagnétique (1; 1a-1c) selon la revendication 3, **caractérisée en ce que** le support de bobine (2) est réalisé à partir d'un matériau électriquement isolant, notamment une matière plastique, dans la région des parois du premier compartiment d'enroulement de joint (23a) et/ou des parois du deuxième compartiment d'enroulement de joint (23b).

5. Section de bobine électromagnétique (1; 1a-1c) selon l'une quelconque des revendications précédentes, **caracté-**

**risée en ce que** :

dans la section extérieure dans le plan axial (14) de la première région latérale (SB1), le support de bobine (2) comporte une première rainure de joint (81) qui conduit de préférence au moins une fois, de façon préférée plusieurs fois, autour du support de bobine (2) et dans laquelle au moins la partie de la première section d'extrémité (11) du conducteur en ruban HTS (10) et la section d'extrémité (31a) du premier conducteur de suite SL (31) sont guidées de façon à reposer l'une sur l'autre ; et/ou

que dans la section extérieure dans le plan axial (14) de la première ou deuxième région latérale (SB1, SB2), le support de bobine (2) comporte une deuxième rainure de joint qui conduit au moins une fois, de façon préférée plusieurs fois, autour du support de bobine (2) dans lequel au moins la partie de la deuxième section d'extrémité (12) du conducteur en ruban HTS (10) et de la section d'extrémité (32a) du deuxième conducteur de suite SL (32) sont guidées de façon à reposer l'une sur l'autre.

6. Section de bobine électromagnétique (1; 1a-1c) selon la revendication 5, **caractérisée en ce que** le support de bobine (2) est réalisé à partir d'un matériau électriquement isolant, notamment d'une matière plastique, dans la région des parois de la première rainure de joint (81) et/ou des parois de la deuxième rainure de joint.

7. Section de bobine électromagnétique (1; 1a-1c) selon l'une quelconque des revendications précédentes, **caractérisée en ce que** la deuxième section d'extrémité (12) du conducteur en ruban HTS (10) est également enroulée sur le support de bobine (2) dans la première région latérale (SB1) ;
dans la section intérieure dans le plan axial (13) de la première région latérale (SB1), les renfoncements de type rainure (15a, 15b) de la première section d'extrémité (11) et de la deuxième section d'extrémité (12) se croisent à plusieurs reprises.

8. Section de bobine électromagnétique (1; 1a-1c) selon la revendication 7, **caractérisée en ce que** le support de bobine (2) est réalisé avec un jeu (5) de coques de support (5a, 5b) dans une région de transition de la section intérieure dans le plan axial (13) de la première région latérale (SB1) connexe dans le plan axial au compartiment d'enroulement principal (8), lesdites coques de support reposant sur le reste du support de bobine (2) et enceignant ensemble de façon annulaire le reste du support de bobine (2) ; et
que dans la région de transition un des renfoncements de type rainure (15a, 15b) prévus pour la première section d'extrémité (11) et la deuxième section d'extrémité (12) du conducteur en ruban HTS (10) est réalisé dans le jeu (5) de coques de support (5a, 5b) et que l'autre des renfoncements de type rainure (15a, 15b) prévus pour la première section d'extrémité (11) et la deuxième section d'extrémité (12) du conducteur en ruban HTS (10) est réalisé dans le plan radial en-dessous du jeu (5) de coques de support (5a, 5b) dans le reste du support de bobine (2), la première et deuxième section d'extrémité (11, 12) du conducteur en ruban HTS (10) se croisant au moins une fois dans la région de transition.

9. Section de bobine électromagnétique (1; 1a-1c) selon la revendication 7 ou 8, **caractérisée en ce que** dans la section intérieure dans le plan axial (13) de la première région latérale (SB1), les renfoncements de type rainure (15a, 15b) prévus pour la première section d'extrémité (11) et la deuxième section d'extrémité (12) du conducteur en ruban HTS (10) sont réalisés avec une profondeur de rainure différente dans au moins une zone d'intersection (25) des renfoncements de type rainure (15a, 15b).

10. Section de bobine électromagnétique (1; 1a-1c) selon l'une quelconque des revendications 7 à 9, **caractérisée en ce que** dans la section extérieure dans le plan axial (14) de la première région latérale (SB1), un renfoncement de type rainure (24) pour la section d'extrémité (11, 12) du conducteur en ruban HTS (10) comportant le joint situé plus à l'extérieur dans le plan axial (21, 22) s'étend dans le plan radial à l'intérieur du joint situé plus à l'intérieur dans le plan axial (21, 22) .

11. Section de bobine électromagnétique (1; 1a-1c) selon l'une quelconque des revendications 7 à 10, **caractérisée en ce que** dans la section extérieure dans le plan axial (14) de la première région latérale (SB1), une rainure d'évacuation (19a, 19b) prévue pour le conducteur de suite SL (31, 32) faisant partie du joint situé plus à l'intérieur dans le plan axial (21, 22) s'étend dans le plan radial à l'intérieur du joint situé plus à l'extérieur dans le plan axial (21, 22).

12. Section de bobine électromagnétique (1; 1a-1c) selon l'une quelconque des revendications précédentes, **caractérisée en ce que** le conducteur en ruban HTS (10) comporte au moins deux rubans partiels HTS (10a, 10b) reliés entre eux de façon conductrice en série par le biais d'au moins un joint intermédiaire (16) ;

les rubans partiels HTS (10a, 10b) étant enroulés sur le support de bobine (2) dans la région de l'au moins un joint intermédiaire (16) dans la première région latérale (SB1) ou dans la deuxième région latérale (SB2), dans la région de l'au moins un joint intermédiaire (16), les rubans partiels HTS (10a, 10b) étant reliés à un ruban de pontage supraconducteur (=SL) commun.

13. Section de bobine électromagnétique (1; 1a-1c) selon la revendication 12, **caractérisée en ce que** le support de bobine (2) forme dans la première région latérale (SB1) ou dans la deuxième région latérale (SB2) deux rainures d'amenée (17a, 17b) pour les rubans partiels HTS (10a, 10b) qui conduisent du compartiment d'enroulement principal (9) à la région de l'au moins un joint intermédiaire (16) et que le support de bobine (2) forme, dans la région de l'joint intermédiaire (16), une rainure intermédiaire de joint (18) pour les rubans partiels HTS (10a, 10b).

14. Section de bobine électromagnétique (1; 1a-1c) selon la revendication 13, **caractérisée en ce que** le support de bobine (2) est réalisé dans la région de l'au moins un joint intermédiaire (16) avec un jeu (7) de coques de séparation (7a, 7b) reposant sur le reste du support de bobine (2) enceignant ensemble de façon annulaire le reste du support de bobine (2) ; et
qu'une partie extérieure dans le plan radial (18b) de la rainure intermédiaire de joint (18) est réalisée dans le jeu (7) de coques de séparation (7a, 7b) et qu'une partie intérieure dans le plan radial (18a) de la rainure intermédiaire de joint (18) est réalisée dans le plan radial en-dessous du jeu (7) de coques de séparation (7a, 7b) dans le reste du support de bobine (2) ;
le jeu (7) de coques de séparation (7a, 7b) comportant notamment une région (29) pour le changement de rayon de l'joint intermédiaire (16).

15. Section de bobine électromagnétique (1; 1a-1c) selon l'une quelconque des revendications 12 à 14, **caractérisée en ce que** dans la première région latérale (SB1), la deuxième section d'extrémité (12) du conducteur en ruban HTS (10) est également enroulée sur le support de bobine (2) et que les rubans partiels HTS (10a, 10b) placés dans la région de l'au moins un joint intermédiaire (16) dans la deuxième région latérale (SB2) sont enroulés sur le support de bobine (2) ;
le support de bobine (2) étant notamment orienté verticalement avec son axe de cylindre (A), ainsi que vers le bas avec la deuxième région latérale (SB2) et vers le haut avec la première région latérale (SB1).

16. Section de bobine électromagnétique (1) selon l'une quelconque des revendications précédentes, **caractérisée en ce que** :

   - les renfoncements de type rainure (15a, 15b, 24) dans lesquels le conducteur en ruban HTS (10) est conduit au moins dans la section située à l'intérieur dans le plan axial (13) de la première et/ou deuxième région latérale (SB1, SB2) ; et
   - le cas échéant les rainures de joint dans lesquelles les première et/ou deuxième sections d'extrémité (11, 12) du conducteur en ruban HTS (10) sont conduites dans la section extérieure dans le plan axial (14) de la première et/ou deuxième région latérale (SB1, SB2) ; et
   - le cas échéant les rainures d'amenée (17a, 17b) et les rainures intermédiaires de joint (18) pour les rubans partiels HTS (10a, 10b) du conducteur en ruban HTS (10) reliées à un joint intermédiaire (16) ;

   sont réalisés au moins en partie avec une base de rainure (33) sur laquelle le conducteur en ruban HTS (10) repose et dont la normale en surface (FN) locale présente un angle s'écartant de 90° ($\alpha$) par rapport à l'axe (A) du support de bobine (2).

17. Section de bobine électromagnétique (1; 1a-1c) selon l'une quelconque des revendications précédentes, **caractérisée en ce que** :

   le premier conducteur de suite SL (31) et/ou le deuxième conducteur de suite SL (32) contient une matière supraconductrice à basse température (=LTS), notamment du NbTi ; et/ou
   que le premier conducteur de suite SL (31) et/ou le deuxième conducteur de suite SL (32) contient du $MgB_2$ ; et/ou
   que le conducteur en ruban HTS (10) contient du ReBCO, notamment du YBCO, ou du Bi2223.

18. Section de bobine électromagnétique (1; 1a-1c) selon l'une quelconque des revendications précédentes, **caractérisée en ce que** dans la première région latérale (SB1), le conducteur en ruban HTS (10) de la première section d'extrémité (11) et dans la première ou deuxième région latérale (SB1, SB2), le conducteur en ruban HTS (10) de la deuxième section d'extrémité (12) sont respectivement enroulés en forme d'hélice, avec une hauteur de rapport augmentant d'abord vers l'extérieur dans le plan axial puis diminuant ensuite de nouveau.

**19.** Section de bobine électromagnétique (1; 1a-1c) selon l'une quelconque des revendications précédentes, **caractérisée en ce que** le premier conducteur de suite SL (31) et le deuxième conducteur de suite SL (32) s'éloignent respectivement dans le plan axial avec une section de liaison (31b, 32b) hors de la section extérieure dans le plan axial (14) de la première ou deuxième région latérale (SB1, SB2).

**20.** Agencement d'aimants (40), comprenant plusieurs sections de bobine électromagnétique (1 ; 1a-1c) selon l'une quelconque des revendications précédentes, les sections de bobine électromagnétique (1 ; 1a-1c) étant disposées de façon à être emboîtées les unes dans les autres, sachant que l'on a notamment, pour une largeur de fente moyenne sur la totalité du périmètre MS d'une fente radiale (45) respective entre les sections de bobine électromagnétique (1 ; 1a-1c) connexes :
MS $\leq$ 1 mm, de façon préférée MS $\leq$ 0,5 mm.

**21.** Agencement d'aimants (40) selon la revendication 20, **caractérisé en ce que** le paquet d'enroulement principal (9) d'une section de bobine électromagnétique (1 ; 1a-1c) intérieure dans le plan radial respective dans le plan radial bute radialement vers l'extérieur contre un côté intérieur du support de bobine (2) de la section de bobine électromagnétique (1 ; 1a-1c) extérieure suivante dans le plan radial ; ou
qu'une fente radiale (45) respective entre des sections de bobine électromagnétique (1; 1a-1c) connexes est remplie d'un matériau de remplissage (44), le matériau de remplissage (44) étant notamment isolant électrique et le matériau de remplissage (44) comprenant notamment une matière coulée durcie et/ou des films.

**22.** Agencement d'aimants (40) selon la revendication 20 ou 21, **caractérisé en ce que** les sections de bobine électromagnétique (1 ; 1a-1c) sont réalisées avec une longueur axiale identique des supports de bobine (2) et que les supports de bobine (2) sont alignés dans le plan axial.

**23.** Agencement d'aimants (40) selon l'une quelconque des revendications 20 à 22, **caractérisé en ce que** les sections de bobine électromagnétique (1 ; 1a-1c) sont reliées entre elles de façon conductrice via leurs premiers conducteurs de suite SL (31) et deuxièmes conducteurs de suite SL (32).

**24.** Agencement d'aimants (40) selon l'une quelconque des revendications 20 à 23, **caractérisé en ce que** l'agencement d'aimants (40) est réalisé pour produire, dans un volume d'essai (PV) d'au moins 0,5 cm$^3$ à l'intérieur de la section de bobine électromagnétique la plus à l'intérieur (1 ; la), un champ magnétique d'une puissance B0 et d'une homogénéité de 100 ppm ou mieux et que les premiers joints (21) et les deuxièmes joints (22), et de façon préférée également le cas échéant le ou les joints intermédiaires (16), des sections de bobine électromagnétique (1; 1a-1c) soient disposés à une certaine distance dans le plan axial du volume d'essai (PV) pour que pour la plus grande puissance de champ magnétique Bjoint au niveau de chacun de ces joints (21, 22, 16), on ait les valeurs suivantes :

Bjoint $\leq$ 1/2*B0 ;
de façon préférée Bjoint $\leq$ 1/10*B0 ;
de façon particulièrement préférée Bjoint $\leq$ 1/50*B0 ;
notamment B0 $\geq$ 20 T.

**25.** Agencement d'aimants (40) selon l'une quelconque des revendications 20 à 23, au moins une des sections de bobine électromagnétique (1 ; 1a-1c) étant réalisée selon la revendication 16, **caractérisé en ce que** :

les sections de bobine électromagnétique (1 ; 1a-1c) sont reliées en série sur le plan électrique ; et
que la normale en surface (FN) locale de la base de rainure (33) s'étend de telle sorte que :

- une flexion sur le bord court du conducteur en ruban HTS (10) reposant sur la base de rainure (33) est si petite qu'une dilatation du conducteur en ruban HTS ne dépasse jamais 0,6 % et ce également au niveau de ses bords, de façon préférée jamais 0,2 %, de façon particulièrement préférée qu'aucune flexion ne se produise sur le bord court du conducteur en ruban HTS (10) reposant sur la base de rainure (33) ; et que et simultanément

- une composante normale locale d'un champ magnétique global produit par l'agencement d'aimants (40) parallèle aux normales en surface locales (FN) de la base de rainure (33) est maximal en valeur perpendiculairement au plan de bande local du conducteur en ruban HTS (10) dans l'ensemble inférieur ou égal à une composante normale de référence du champ magnétique présente au niveau du conducteur en ruban HTS (10) dans les enroulements les plus à l'extérieur dans le plan axial du paquet d'enroulement principal (9).

**Fig. 1**

Fig. 2a

Fig. 2b

EP 3 772 071 B1

**Fig. 3a**

**Fig. 3b**

**Fig. 3c**

**Fig. 3d**

30

HB

**Fig. 4a**

SB2

8

10/10a

10/10b

3

2

10/10a

17b

17a

10/10b

2

7a  7b  7

10/28

**Fig. 4b**

16

**Fig. 4d**

7

**Fig. 4c**  7b

7a

18/18a

18/18b

30

29

**Fig. 5**

32/32b

32/32a

10/12

22

SB1

10/12

27/9

HB

**Fig. 6**

**Fig. 7**

31b

1

21

15a

SB1

15a

15a

9/10

HB

9/10

15b

2

15b

SB2

15b

22

32b

**Fig. 8**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10202372 B4
- GB 2388909 A
- US 3559128 A
- DE 10260728 B4
- EP 2645382 A
- DE 102013220142 A1

**In der Beschreibung aufgeführte Nicht-Patentliteratur**

- **MANFREDO P. DO CARMO.** Differentialgeometrie von Kurven und Flächen. Vieweg Verlag, 1983, 240